# EUROPEAN PATENT SPECIFICATION

(11) **EP 3 296 999 B1**
(45) Date of publication and mention of the grant of the patent: **27.02.2019**
(21) Application number: 17186615.5
(22) Date of filing: 17.08.2017
(51) Int. Cl.: G21C 17/022

(54) **ADHESION METHOD OF NOBLE METAL TO CARBON STEEL MATERIAL OF ATOMIC ENERGY PLANT AND ADHESION RESTRAINT METHOD OF RADIONUCLIDE TO CARBON STEEL MATERIAL OF ATOMIC ENERGY PLANT**
KLEBEVERFAHREN VON EDELMETALL AN KOHLENSTOFFSTAHLMATERIAL EINER ATOMENERGIEANLAGE UND KLEBERÜCKHALTEVERFAHREN VON RADIONUKLIDEN AN KOHLENSTOFFSTAHLMATERIAL VON ATOMENERGIEANLAGEN
PROCÉDÉ D'ADHÉRENCE D'UN MÉTAL NOBLE À UN MATÉRIAU D'ACIER AU CARBONE D'UNE INSTALLATION DE PRODUCTION D'ÉNERGIE ATOMIQUE ET PROCÉDÉ DE RETENUE D'ADHÉRENCE D'UN RADIONUCLÉIDE À UN MATÉRIAU D'ACIER AU CARBONE D'UNE INSTALLATION DE PRODUCTION D'ÉNERGIE ATOMIQUE

(30) Priority: 20.09.2016 JP 2016182928
(43) Date of publication of application: 21.03.2018
(73) Proprietor: Hitachi-GE Nuclear Energy, Ltd., Hitachi-shi Ibaraki 317-0073 (JP)
(72) Inventor: ITOU, Tsuyoshi, Tokyo 100-8280 (JP); HOSOKAWA, Hideyuki, Tokyo 100-8280 (JP); OOTA, Nobuyuki, Hitachi-shi Ibaraki 317-0073 (JP); OOUCHI, Satoshi, Hitachi-shi Ibaraki 317-0073 (JP); YANAGISAWA, Shintarou, Hitachi-shi Ibaraki 317-0073 (JP); TSUYUKI, Mizuho, Hitachi-shi Ibaraki 317-0073 (JP); NAGASE, Makoto, Hitachi-shi Ibaraki 317-0073 (JP); ISHIDA, Kazushige, Tokyo 100-8280 (JP); KAWASAKI, Toru, Hitachi-shi Ibaraki 317-0073 (JP)
(74) Representative: MERH-IP Matias Erny Reichl Hoffmann Patentanwälte PartG mbB

(56) References cited:
- JP-A- H08 220 293
- JP-A- 2016 161 466

## Description

### Technical Field

The present invention relates to an adhesion method of noble metal to a carbon steel material of an atomic energy plant and an adhesion restraint method of a radionuclide to the carbon steel material of the atomic energy plant, and particularly to an adhesion method of noble metal to a carbon steel material of an atomic energy plant and an adhesion restraint method of a radionuclide to the carbon steel material of the atomic energy plant, which are suitably used in being applied to a boiling-water nuclear power plant.

### Background Art

As an atomic energy plant, for example, a boiling-water nuclear power plant (referred to as a BWR plant below) and a pressurized-water nuclear power plant (referred to as a PWR plant) are known. For example, in the BWR plant, steam generated in a reactor pressure vessel (referred to as an RPV) is guided to a turbine so as to rotate the turbine. Steam discharged from the turbine is condensed in a condenser, and thus turns into water. The water is fed to the RPV through a feedwater pipe, as feedwater. In order to suppress generation of a radioactive corrosion product in the RPV, metal impurities included in the feedwater are removed in a filter demineralizer provided in the feedwater pipe.

In the BWR plant and the PWR plant, regarding the main components such as the RPV, stainless steel, a nickel-base alloy, and the like are used at portions thereof which are in contact with water, in order to suppress an occurrence of corrosion. From a viewpoint of reducing fabrication cost of a plant, or a viewpoint of avoiding an occurrence of stress corrosion cracking of stainless steel occurring by high-temperature water which flows in a feedwater system, a carbon steel material is mainly used in components such as a reactor purification system, a residual heat removal system, a reactor core isolation cooling system, a reactor core spray system, and the feedwater system.

Further, a portion of reactor water (cooling water in the RPV) is purified by a reactor water purification device in the reactor purification system, and metal impurities which are small in the reactor water are actively removed.

However, even though corrosion prevention measures as described above are provided, even small metal impurities are necessarily provided in the reactor water. Thus, some metal impurities adhere to an outer surface of a fuel rod included in a fuel assembly, in a form of metal oxide. Metal elements included in the metal impurities which adhere to the outer surface of the fuel rod cause a nuclear reaction by irradiation with neutrons emitted from a nuclear fuel material in the fuel rod, and thus turn into radionuclides such as cobalt 60, cobalt 58, chrome 51, and manganese 54. Some radionuclides which adhere to the outer surface of the fuel rod in a form of oxide are eluted into the reactor water in a form of ions, in accordance with solubility of the adhered oxide. The eluted radionuclides are discharged again into the reactor water in a form of an insoluble solid referred to as crud. Radionuclides which do not have been removed in the reactor purification system are accumulated on a surface of the component, which comes into contact with the reactor water, during a period when the radionuclides circulate along with the reactor water in a recirculation system and the like. As a result, radiations are emitted from the surface of the component, and this is the cause of radiation exposure of employees when doing periodic checking work. The exposure dose of the employee is managed so as not to exceed a required value for each person. However, recently, a necessity that the required value is reduced and the exposure dose of each person is economically reduced as much as possible arises.

Chemical decontamination is proposed (JP-A-2000-105295). In the chemical decontamination, an oxide film which has been formed on the surface of the component of an atomic energy plant which has performed an operation, for example, on the surface of a pipe, and which includes radionuclides such as cobalt 60 and cobalt 58 is removed by dissolution using chemicals.

Regarding a method of reducing adhering of radionuclides to a pipe, various researches are performed. For example, JP-A-8-220293 discloses that metal ions of zinc, nickel, and the like are injected into reactor water, and thus zinc and nickel are adhered to the surface of the component, in order to restrain adhering of radionuclides to the surface of the component of an atomic energy plant.

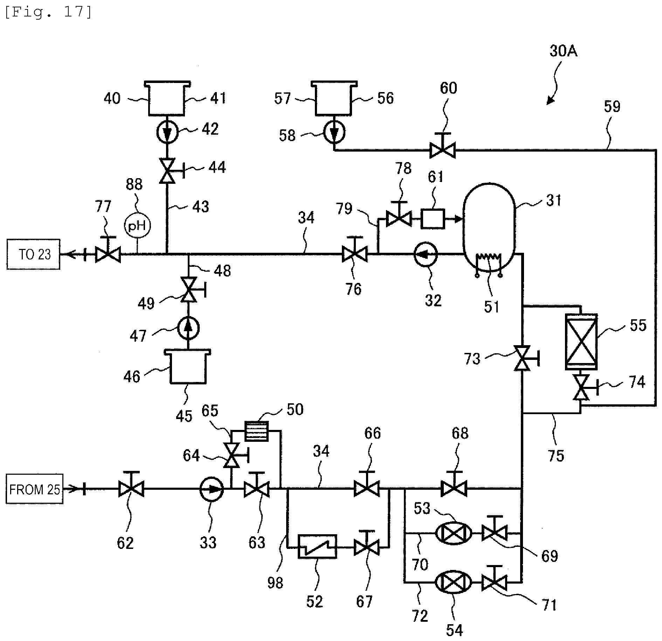

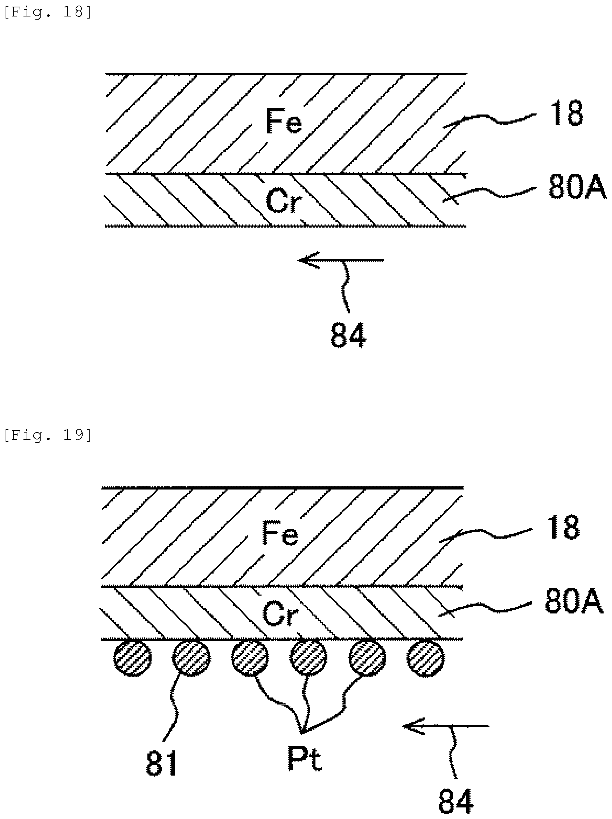

JP-A-2006-38483 discloses a method in which a magnetite film which is one kind of a ferrite film is formed on the surface of the component of an atomic energy plant after chemical decontamination, and thus radionuclides are restrained from adhering to the surface of the component of a plant after the plant operates. JP-A-2006-38483 discloses that a magnetite film is formed on the surface of the component, and then an atomic energy plant starts, and reactor water into which noble metal is injected is brought into contact with the magnetite film so as to adhere the noble metal onto the magnetite film (see Figs. 17 and 18).

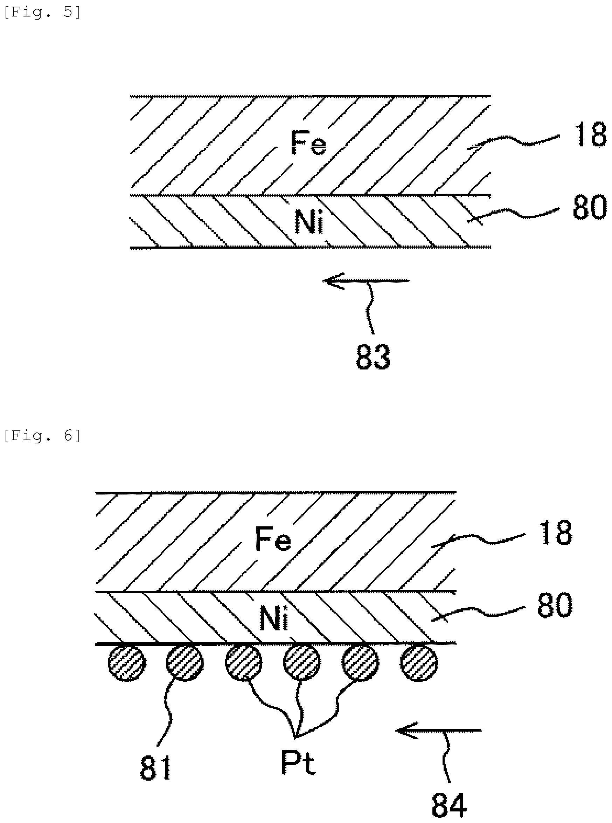

JP-A-2007-182604 discloses that, after chemical decontamination, a film forming liquid which includes iron (II) ions, nickel ions, an oxidant, and a pH regulator (for example, hydrazine) and has a temperature range of 60°C to 100°C is brought into contact with the surface of a carbon steel component of an atomic energy plant so as to form a nickel ferrite film on the surface of the component during a period when an operation of the atomic energy plant is suspended (see Fig. 6) . The nickel ferrite film is formed, and thus corrosion of the carbon steel component is restrained, and adhering of radionuclides to the component is restrained.

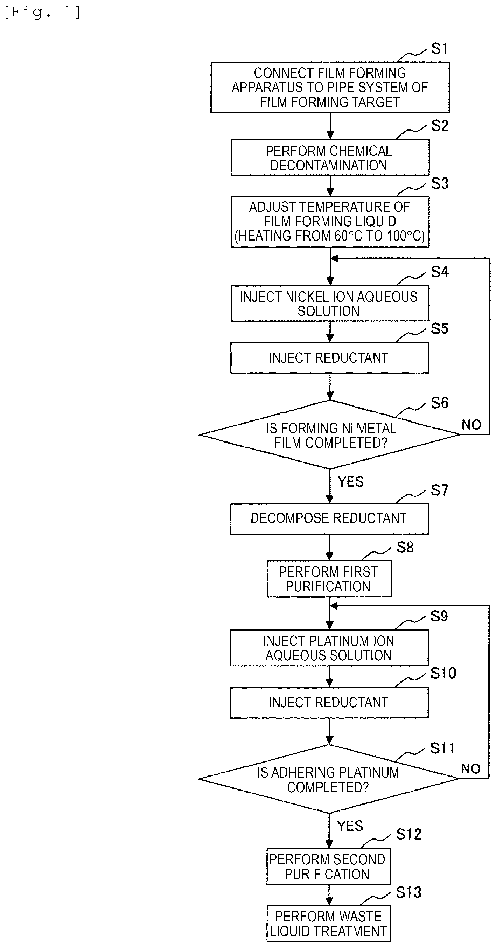

JP-A-2012-247322 discloses that a film forming liquid which includes iron (II) ions, an oxidant, and a pH regulator (hydrazine) and has a temperature range of 60°C to 100°C is brought into contact with the surface of a component of an atomic energy plant, which is subjected to chemical decontamination and is made of stainless steel, so as to form a magnetite film on the surface of the component during a period when an operation of the atomic energy plant is suspended. JP-A-2012-247322 also discloses that an aqueous solution including noble metal (for example, platinum) is brought into contact with the formed magnetite film so as to adhere the noble metal onto the magnetite film during operation suspension (see Fig. 1).

JP-A-2014-44190 discloses an adhesion method of noble metal to a component of an atomic energy plant. In the adhesion method of noble metal, in chemical decontamination performed during a period when an operation of an atomic energy plant is suspended, adhering of noble metal (for example, platinum) to the surface of a stainless-steel component is performed in a state where a portion of a deoxidizing decontamination agent is decomposed (see Figs. 1 and 3), or adhering of noble metal to the surface of a component is performed in a purification process after a deoxidizing decontamination agent decomposition process (see Fig. 16). Noble metal adheres to the surface of the component, and thus adhering of radionuclides to the surface thereof is restrained.

### Citation List

### Patent Literature

PTL 1: JP-A-8-220293
PTL 2: JP-A-2000-105295
PTL 3: JP-A-2006-38483
PTL 4: JP-A-2007-182604
PTL 5: JP-A-2012-247322
PTL 6: JP-A-2014-44190

### Summary of Invention

### Technical Problem

It is desirable that a time taken to adhere noble metal to a carbon steel component (carbon steel material) of an atomic energy plant is reduced.

In a case where metal ions of zinc, nickel, and the like are injected into reactor water so as to adhere metal such as zinc and nickel to the surface of a component of an atomic energy plant, adhering of radionuclides to a stainless-steel component is restrained. However, regarding a carbon steel component (carbon steel material), an adhesion restraint effect of radionuclide is degraded in comparison to the stainless-steel component. Also regarding adhering of noble metal, in a case where noble metal is adhered to the surface of a carbon steel component, the adhesion restraint effect of radionuclide is degraded in comparison to a case where the noble metal is adhered to the surface of the stainless-steel component.

It is desirable that adhering of radionuclides to a carbon steel material of an atomic energy plant is restrained and an adhesion restraint effect continues for a long term.

A first object of the present invention is to provide an adhesion method of noble metal to a carbon steel material of an atomic energy plant, in which a time taken to adhere the noble metal to the carbon steel material can be reduced.

A second object of the present invention is to provide an adhesion restraint method of a radionuclide to a carbon steel material of an atomic energy plant, in which an adhesion restraint effect of the radionuclide to the carbon steel material can continue for a longer term.

### Solution to Problem

A first aspect of the invention for achieving the above-described first object includes forming either a nickel metal film or a chrome metal film on a surface of a carbon steel material of an atomic energy plant, which comes into contact with cooling water, so as to cover the surface with the formed metal film, and adhering noble metal to the surface of the formed metal film. The forming of either the nickel metal film or the chrome metal film, and the adhering of the noble metal are performed when the atomic energy plant is suspended.

Since the surface of the carbon steel material of the atomic energy plant is covered by either the nickel metal film or the chrome metal film, it is possible to prevent elution of Fe²⁺ to a film forming aqueous solution from the carbon steel material. In addition, a situation in which adhering of noble metal to the surface of the carbon steel material is hindered by the elution of Fe²⁺ does not occur, and it is possible to reduce a time taken to adhere the noble metal to the surface of the carbon steel material.

Preferably, it is desirable that the nickel metal film is formed on an inner surface of a first pipe in a manner that the film forming aqueous solution is supplied to the first pipe which communicates with a reactor pressure vessel and is the carbon steel material, through a second pipe, and the film forming aqueous solution is brought into contact with the inner surface of the first pipe and the noble metal is adhered in a manner that the aqueous solution including the noble metal ion and the reductant is supplied to the first pipe through the second pipe, and the aqueous solution is brought into contact with the surface of the nickel metal film, which has been formed on the inner surface of the first pipe.

Preferably, it is desirable that the chrome metal film is formed by evaporating chrome to an inner surface of a plurality of pipe constituents as the carbon steel material, the plurality of pipe constituents having an inner surface on which the chrome metal film has been formed by evaporating chrome is welded so as to form a first pipe which communicates with a reactor pressure vessel and is the carbon steel material, and the noble metal is adhered in a manner that an aqueous solution including a noble metal ion and a reductant is supplied to the first pipe through a second pipe, and the aqueous solution is brought into contact with a surface of the chrome metal film which has been formed on an inner surface of the first pipe.

A second aspect of the invention for achieving the above-described second object includes forming a nickel metal film on a surface of a carbon steel material of an atomic energy plant, which comes into contact with cooling water, so as to cover the surface thereof with the nickel metal film, and adhering noble metal to the surface of the nickel metal film. The forming of the nickel metal film and the adhering of the noble metal are performed before the atomic energy plant starts after an operation of the atomic energy plant is suspended. Water which includes an oxidant (oxygen, hydrogen peroxide, and the like) and has a temperature range of 200°C to 330°C is brought into contact with the nickel metal film to which the noble metal adheres, so as to convert the nickel metal film into a nickel ferrite film.

Corrosion potentials of the nickel metal film which comes into contact with the water, and the carbon steel material are decreased by an action of the noble metal which adheres to the nickel metal film. As described above, the corrosion potentials are decreased, and the water including the oxidant is brought into contact with the nickel metal film, and thus the carbon steel material and the nickel metal film have a temperature range of 200°C to 330°C. Thus, the oxidant included in the water and oxygen constituting some water molecules of the water are transferred to the nickel metal film. In addition, Fe²⁺ is transferred from the carbon steel material to the nickel metal film. Thus, the nickel metal film is converted into the nickel ferrite film which is stable, that is, is not eluted into cooling water with which a contact is performed, even by the action of the adhering noble metal in the atomic energy plant. It is possible to cause an adhesion restraint effect of a radionuclide to the carbon steel material to continue for a longer term by the nickel ferrite film which covers the surface of the carbon steel material and is so stable.

Preferably, it is desirable that, when the atomic energy plant operates, the cooling water which is water which includes the oxidant and has a temperature range of 200°C to 330°C, and has a temperature range of 200°C to 330°C in the reactor pressure vessel is brought into contact with the nickel metal film.

A third aspect of the invention for achieving the above-described second object includes forming a chrome metal film on a surface of the carbon steel material of the atomic energy plant, which comes into contact with cooling water, so as to cover the surface with the chrome metal film, and adhering noble metal to the surface of the chrome metal film. The forming of the chrome metal film, and the adhering of the noble metal are performed when the atomic energy plant is suspended. Water which includes an oxidant and has a temperature range of 200°C to 330°C is brought into contact with the chrome metal film to which the noble metal adheres, so as to convert the chrome metal film into a chrome ferrite film.

Preferably, it is desirable that the chrome metal film is formed by evaporating chrome to an inner surface of a plurality of pipe constituents as the carbon steel material, the plurality of pipe constituents having an inner surface on which the chrome metal film has been formed by evaporating chrome is welded so as to form a first pipe which communicates with a reactor pressure vessel and is the carbon steel material, and the noble metal is adhered in a manner that an aqueous solution including a noble metal ion and a reductant is supplied to the first pipe through a second pipe, and the aqueous solution is brought into contact with a surface of the chrome metal film which has been formed on an inner surface of the first pipe. In addition, it is desirable that the second pipe is detached from the first pipe, water which includes an oxidant and has a temperature range of 200°C to 330°C is supplied to the first pipe, after the detaching, and the water including the oxidant is brought into contact with the chrome metal film which has been formed on an inner surface of the first pipe and has the adhering noble metal, so as to convert the chrome metal film into a chrome ferrite film to which the noble metal adheres.

### Advantageous Effects of Invention

According to the first aspect of the invention, it is possible to reduce a time taken to adhere noble metal to the carbon steel material of the atomic energy plant.

According to the second aspect and the third aspect of the invention, it is possible to cause the adhesion restraint effect of a radionuclide to the carbon steel material of the atomic energy plant to continue for a longer term.

### Brief Description of Drawings

[Fig. 1] Fig. 1 is a flowchart illustrating procedures of an adhesion method of noble metal to a carbon steel material of an atomic energy plant according to Example 1 which is a preferred example of the present invention, and is applied to a purification system pipe of a boiling-water nuclear power plant.

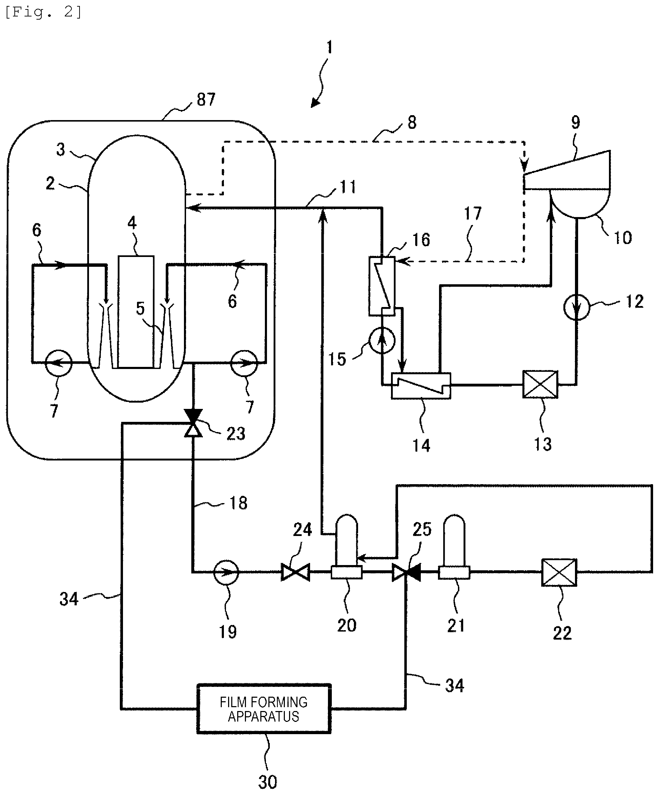

[Fig. 2] Fig. 2 is a diagram illustrating a state where a film forming apparatus used when the adhesion method of the noble metal to the carbon steel material of the atomic energy plant illustrated in Fig. 1 is performed is connected to the purification system pipe of the boiling-water nuclear power plant.

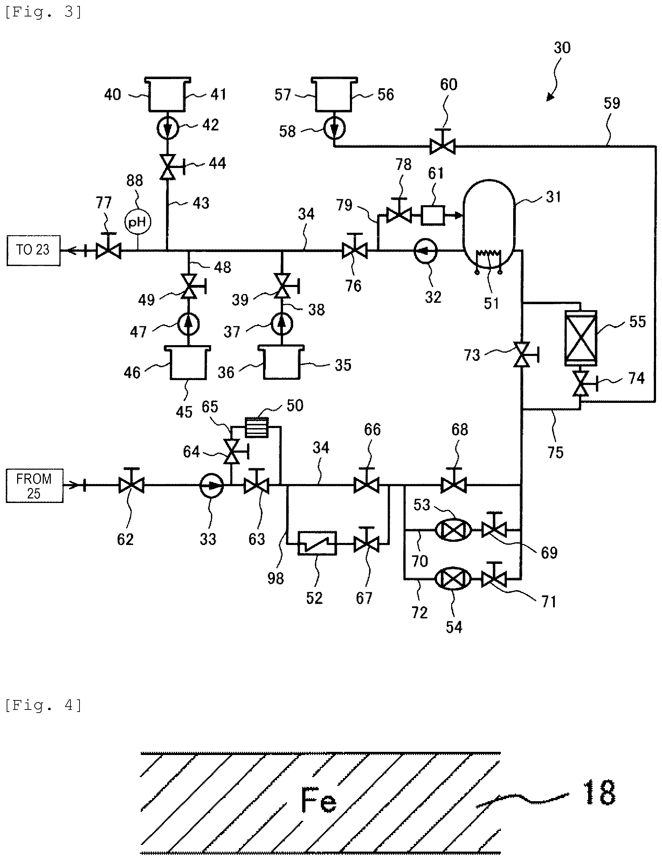

[Fig. 3] Fig. 3 is a detailed configuration diagram illustrating the film forming apparatus illustrated in Fig. 2.
[Fig. 4] Fig. 4 is a sectional view illustrating the purification system pipe before the adhesion method of the noble metal to the carbon steel material of the atomic energy plant illustrated in Fig. 1 is started.
[Fig. 5] Fig. 5 is a diagram illustrating a state where a nickel metal film is formed on an inner surface of the purification system pipe by the adhesion method of the noble metal to the carbon steel material of the atomic energy plant illustrated in Fig. 1.
   [Fig. 6] Fig. 6 is a diagram illustrating a state where noble metal is adhered to the surface of the nickel metal film which is formed on the inner surface of the purification system pipe by the adhesion method of the noble metal to the carbon steel material of the atomic energy plant illustrated in Fig. 1.

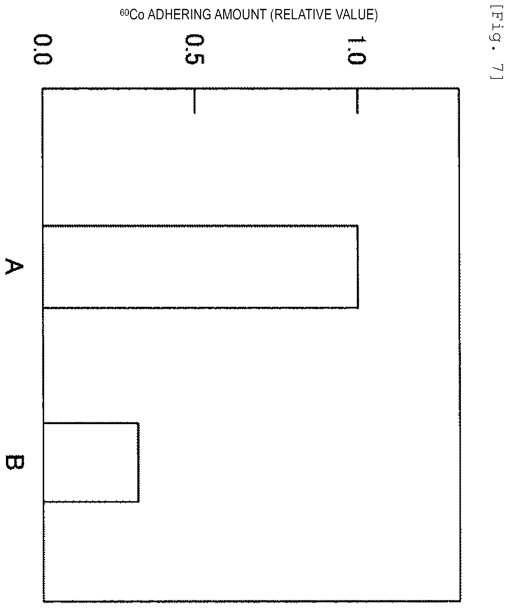

[Fig. 7] Fig. 7 is a diagram illustrating a result of a Co-60 adhesion test to a carbon steel test piece.

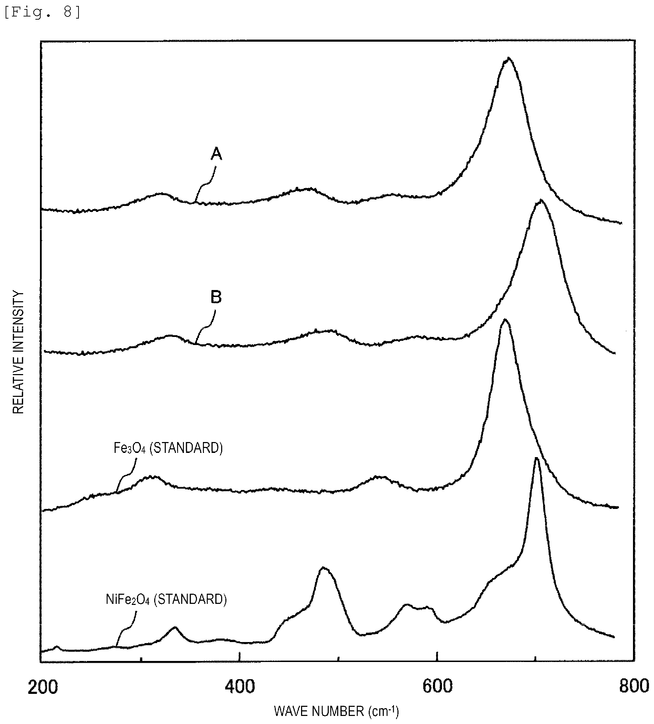

[Fig. 8] Fig. 8 is a diagram illustrating a result of laser Raman spectral analysis of an oxide film which is formed on the carbon steel test piece by the Co-60 adhesion test using the carbon steel test piece on which a nickel metal film having platinum adhering thereto has formed.

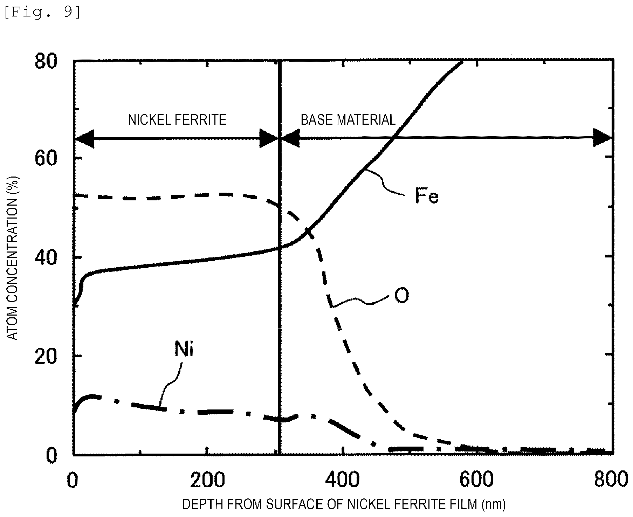

[Fig. 9] Fig. 9 is a diagram illustrating a result of Auger spectral analysis of an oxide film which is formed on the carbon steel test piece by the Co-60 adhesion test using the carbon steel test piece on which a nickel metal film having platinum adhering thereto has formed.

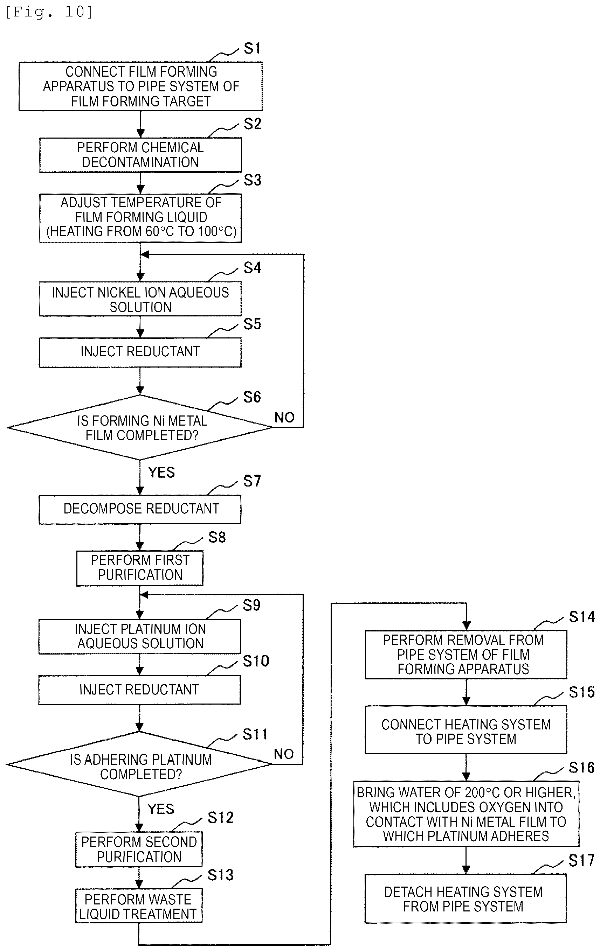

[Fig. 10] Fig. 10 is a flowchart illustrating procedures of an adhesion restraint method of a radionuclide to a carbon steel material of an atomic energy plant according to Example 2 which is another preferred example of the present invention, and is applied to the purification system pipe of the boiling-water nuclear power plant.

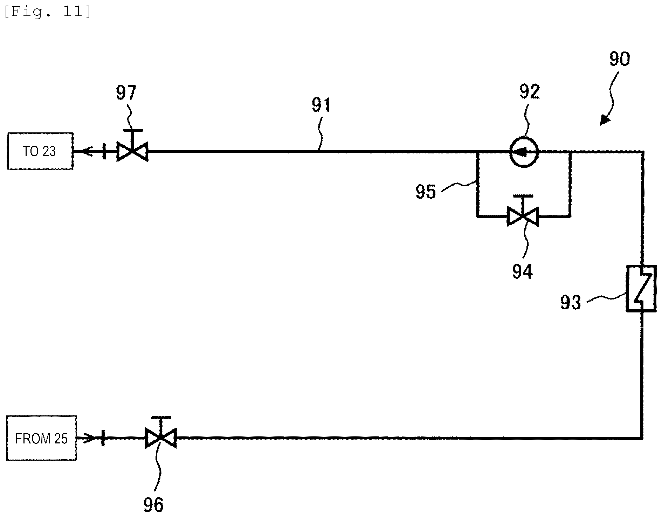

[Fig. 11] Fig. 11 is a configuration diagram illustrating a heating system connected to a purification system pipe for converting a nickel metal film which has been formed on an inner surface of the purification system pipe into a nickel ferrite film in the adhesion restraint method of a radionuclide to the carbon steel material of the atomic energy plant illustrated in Fig. 10.

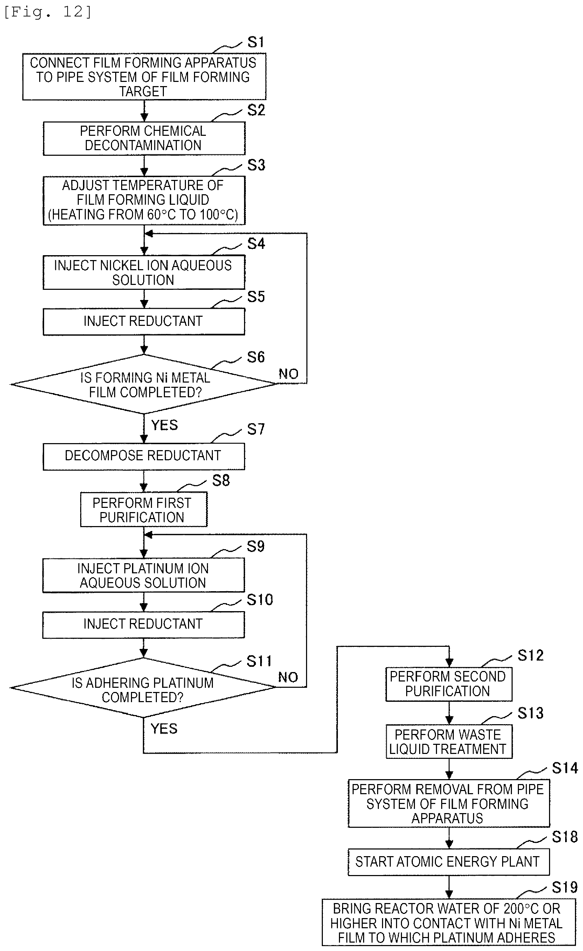

[Fig. 12] Fig. 12 is a flowchart illustrating procedures of an adhesion restraint method of a radionuclide to a carbon steel material of an atomic energy plant according to Example 3 which is still another preferred example of the present invention, and is applied to the purification system pipe of the boiling-water nuclear power plant.

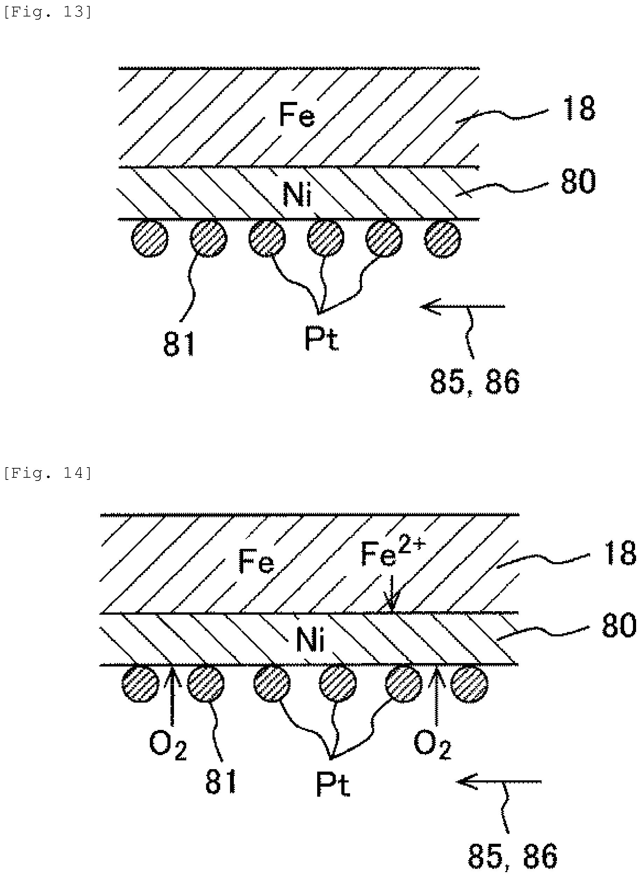

[Fig. 13] Fig. 13 is a diagram illustrating a state of bringing water which includes oxygen and has a temperature range of 200°C to 330°C into contact with the nickel metal film which has been formed on the inner surface of the purification system pipe and has platinum adhering thereto, in each of the adhesion restraint methods of a radionuclide to the carbon steel material of the atomic energy plant illustrated in Figs. 10 and 12.
[Fig. 14] Fig. 14 is a diagram illustrating a state where oxygen included in water having a temperature range of 200°C to 330°C and Fe²⁺ in the purification system pipe are transferred to the nickel metal film which has been formed on the inner surface of the purification system pipe and has platinum adhering thereto, in each of the adhesion restraint methods of a radionuclide to the carbon steel material of the atomic energy plant illustrated in Figs. 10 and 12.

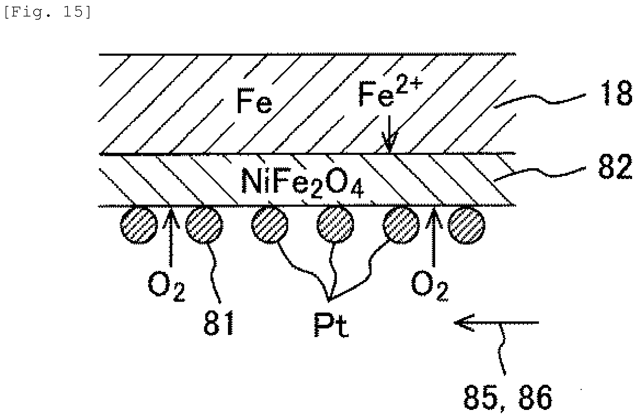

[Fig. 15] Fig. 15 is a diagram illustrating a state where the nickel metal film formed on the inner surface of the purification system pipe is changed to a nickel ferrite film, in each of the adhesion restraint methods of a radionuclide to the carbon steel material of the atomic energy plant illustrated in Figs. 10 and 12.

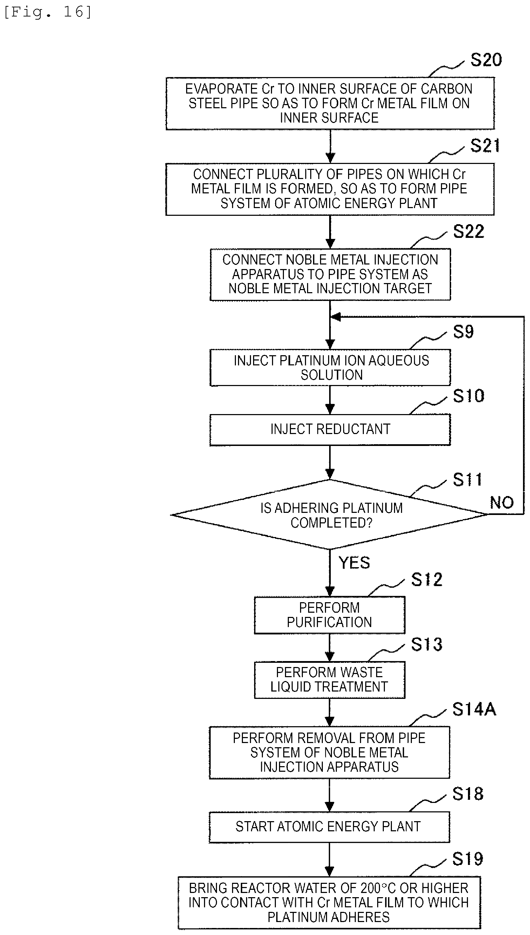

[Fig. 16] Fig. 16 is a flowchart illustrating procedures of an adhesion restraint method of a radionuclide to a carbon steel material of an atomic energy plant according to Example 4 which is still another preferred example of the present invention, and is applied to the purification system pipe of the boiling-water nuclear power plant.
[Fig. 17] Fig. 17 is a detailed configuration diagram illustrating a noble metal injection apparatus connected to the purification system pipe of the boiling-water nuclear power plant, in the adhesion restraint method of a radionuclide to the carbon steel material of the atomic energy plant illustrated in Fig. 16.
[Fig. 18] Fig. 18 is a diagram illustrating a state where an aqueous solution including a platinum ion is in contact with the surface of a chrome metal film formed in the purification system pipe, in the adhesion restraint method of a radionuclide to the carbon steel material of the atomic energy plant illustrated in Fig. 16.
[Fig. 19] Fig. 19 is a diagram illustrating a state where platinum is adhered to the surface of the chrome metal film formed on an inner surface of the purification system pipe, by the adhesion restraint method of a radionuclide to the carbon steel material of the atomic energy plant illustrated in Fig. 16.

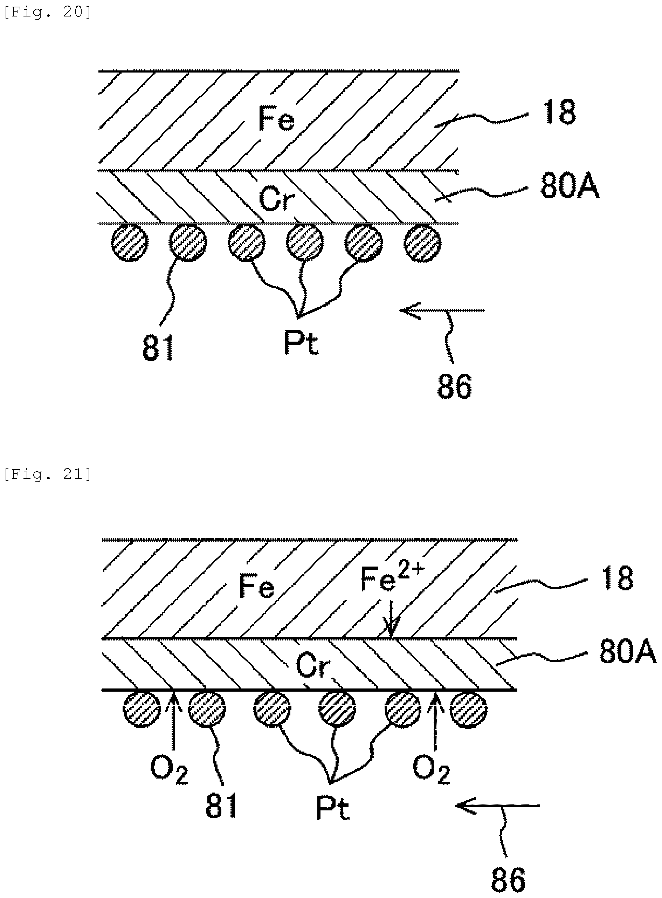

[Fig. 20] Fig. 20 is a diagram illustrating a state of bringing reactor water which includes oxygen and has a temperature range of 200°C to 330°C into contact with the chrome metal film which has been formed on the inner surface of the purification system pipe and has platinum adhering thereto, in the adhesion restraint method of a radionuclide to the carbon steel material of the atomic energy plant illustrated in Fig. 16.
[Fig. 21] Fig. 21 is a diagram illustrating a state where oxygen included in reactor water having a temperature range of 200°C to 330°C and Fe²⁺ in the purification system pipe are transferred to the chrome metal film which has been formed on the inner surface of the purification system pipe and has platinum adhering thereto, in the adhesion restraint method of a radionuclide to the carbon steel material of the atomic energy plant illustrated in Fig. 16.

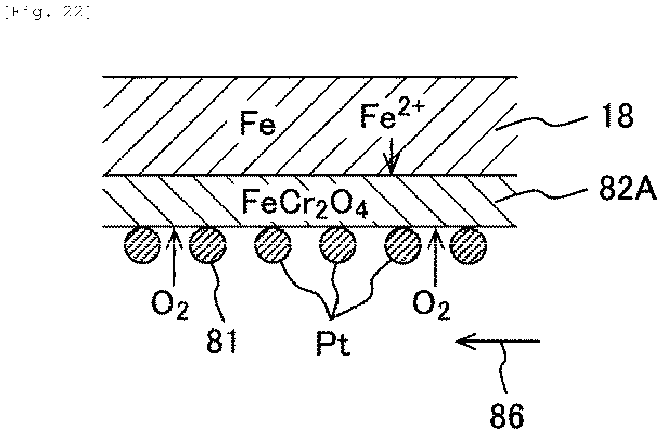

[Fig. 22] Fig. 22 is a diagram illustrating a state where the chrome metal film formed on the inner surface of the purification system pipe is changed to a chrome ferrite film, in the adhesion restraint method of a radionuclide to the carbon steel material of the atomic energy plant illustrated in Fig. 16.

### Description of Embodiments

The inventors had performed various examinations for measures for allowing adhering of radionuclide to a carbon steel component of an atomic energy plant, that is, a carbon component to be restrained.

As described above, in a case where nickel or platinum is adhered to a surface of a carbon steel material, which comes into contact with reactor water, an adhesion restraint effect of a radionuclide to the surface thereof is decreased in comparison to a case where nickel or platinum is adhered to a surface of a stainless-steel component, which comes into contact with reactor water.

In order to improve the decrease of the adhesion restraint effect of a radionuclide as described above, the inventors found that noble metal (for example, platinum) was adhered to a surface of a carbon steel component, which came into contact with reactor water, and then nickel was adhered to a surface of the carbon steel material, noble metal was adhered to a surface of the carbon steel material, to which nickel had been adhered, and thus the amount of the radionuclide adhering to the surface of the carbon steel material was significantly reduced (see Japanese Patent Application No. 2015-41991) .

The inventors considered that noble metal and nickel were adhered to the surface of the carbon steel material, and thus adhering of a radionuclide to the surface thereof was restrained, based on such a new knowledge. The inventors perform examinations for countermeasures for allowing adhering of a radionuclide to the surface thereof to be further restrained, on the assumption that the noble metal and nickel were adhered to the surface of the carbon steel material.

As disclosed in JP-A-2006-38483 and JP-A-2012-247322, the inventors found a phenomenon as follows. In the phenomenon, a film forming liquid which includes iron (II) ions, an oxidant, and a pH regulator (for example, hydrazine) and has a low temperature range of 60°C to 100°C is brought into contact with the surface of the component in the atomic energy plant, so as to form a magnetite film on the surface of the component. In a case where noble metal was adhered onto the magnetite film, a phenomenon in that the magnetite film was eluted into the reactor water by an action of the noble metal was found when the atomic energy plant operated in one operation cycle (for example, period of one year) just after the magnetite film had been formed. Even in a case where noble metal had been adhered onto a nickel ferrite film formed on a surface of the carbon steel material, which came into contact with the reactor water in a low temperature range of 60°C to 100°C, a phenomenon in that nickel ferrite film was eluted into the reactor water by the action of the noble metal was found when the atomic energy plant operated. It was determined that such elution of the ferrite film from the surface of the carbon steel material caused loss of the ferrite film on the carbon steel material, and a radionuclide adhered to the surface of the carbon steel material after the ferrite film had been lost, that is, at the end of the one operation cycle. As a result, adhesion suppression of a radionuclide to the surface of the carbon steel material for a long term is hindered. It is necessary that the ferrite film is formed again on the surface of the carbon steel material after the operation of the atomic energy plant is suspended in this operation cycle. In addition, the ferrite film is required to be formed every time the operation cycle is suspended.

Considering elution of the ferrite film such as the magnetite film and the nickel ferrite film on which noble metal was adhered to the surface, the inventors considered that it was important to restrain adhering of a radionuclide to the surface thereof for a long term, in addition to further restraint of the radionuclide to the surface of the carbon steel material.

The inventors examined a reason that nickel ferrite when noble metal was adhered onto the nickel ferrite film formed on the surface of the carbon steel material in a low temperature range of 60°C to 100°C, which came into contact with the reactor water was eluted. With the examinations, the followings were understood. When the operation of the atomic energy plant was suspended, a film of nickel ferrite, which had been formed on the surface of the carbon steel material, in such a low temperature range was a film of Ni_{0.7}Fe_{2.3}O₄ and was unstable. Ni_{0.7}Fe_{2.3}O₄ has a state in a case where x in Ni₁₋ₓFe₂₊ₓO₄ indicates 0.3. Thus, the followings were understood. When, for example, platinum was adhered onto the film of Ni_{0.7}Fe_{2.3}O₄, which was unstable film, Ni_{0.7}Fe_{2.3}O₄ was eluted into the reactor water by an action of the platinum during the operation of the atomic energy plant. Since the unstable film of Ni_{0.7}Fe_{2.3}O₄ is formed in the low temperature range, a state where many of small grains of Ni_{0.7}Fe_{2.3}O₄ adhere to the surface of the carbon steel material occurs. Even in this case, the film of Ni_{0.7}Fe_{2.3}O₄, which has platinum adhering to an upper surface is eluted.

When noble metal is adhered to the surface of the carbon steel material, if Fe included in the carbon steel material is eluted in a form of Fe²⁺, the noble metal does not adhere to the surface of the carbon steel material. Thus, the inventors examined measures for preventing elution of Fe²⁺ from the carbon steel material when noble metal was adhered to the surface of the carbon steel material. The inventors found that the surface of the carbon steel material was covered with the film of nickel metal, and thus it was possible to prevent elution of Fe²⁺ from the carbon steel material. As will be described later, nickel metal which covers the surface of the carbon steel material is a substance contributing to restrain adhering of a radionuclide to the carbon steel material, and to form a nickel ferrite film which is stable and is not eluted even by the action of the adhering noble metal. The nickel metal film was formed on the surface of the carbon steel material and the surface of the carbon steel material was covered with the formed nickel metal film, and thus it was possible to prevent elution of Fe²⁺ from the carbon steel material, and to adhere noble metal to the surface of the nickel metal film, specifically, to adhere noble metal to the carbon steel material for a short term. In addition, the amount of the noble metal adhering to the carbon steel material was also increased.

The nickel metal film can be formed on the surface of the carbon steel material in a manner that an aqueous solution including nickel ions and a reductant is brought into contact with the surface of the carbon steel material. The nickel ions included in the aqueous solution are substituted with Fe included in the carbon steel material, and the substituted nickel ions form nickel metal by an action of the reductant so as to form the nickel metal film on the surface of the carbon steel material. The noble metal can adhere to the surface of the nickel metal film formed on the surface of the carbon steel material in a manner that an aqueous solution including noble metal ions (for example, platinum ions) and a reductant is brought into contact with the formed nickel metal film.

As described above, the nickel metal film is formed on the surface of the carbon steel material, and thus it is possible to prevent elution of Fe²⁺ from the carbon steel material and to adhere noble metal to the carbon steel material more for a short term.

Further, an examination result relating to adhesion restraint of a radionuclide to the surface of the carbon steel material for a long term will be described below. The inventors intended that contact with the surface of the carbon steel material not caused a film of Ni_{0.7}Fe_{2.3}O₄ which was unstable in a low temperature range of 60°C to 100°C to be formed, but caused a stable nickel ferrite film which had not been eluted even by adhering noble metal to be formed on the surface of a carbon steel material. The inventors performed various examinations of how a nickel metal film formed on the surface of the carbon steel material was allowed to be used in forming on the surface of the carbon steel material of the stable nickel ferrite film, in order to effectively adhere noble metal to the carbon steel material. As a result, water of a high temperature (200°C or higher), which included an oxidant was brought into contact with the surface (to which the noble metal adheres) of the nickel metal film formed on the surface of the carbon steel material, and thus it was possible to convert the nickel metal film into a nickel ferrite film (nickel ferrite film in which x was 0 in Ni₁₋ₓFe₂₊ₓO₄) which covered the surface of the carbon steel material and was stable and not eluted even by the action of the noble metal.

The inventors perform an examination of confirming adhering of Co-60 which was a radionuclide, by using a carbon steel test piece A and a carbon steel test piece B. Nickel and platinum did not adhere to the carbon steel test piece A, and platinum was adhered to the surface of a nickel metal film by forming the nickel metal film on the surface of the carbon steel test piece B. The examination was performed in a manner that the test pieces A and B were installed in a circulation pipe of a closed loop and plotted dummy water circulated reactor water in a nuclear reactor in the circulation pipe. The circulating dummy water includes Co-60, and the temperature of the dummy water is 280°C. Each of the test pieces A and B installed in the circulation pipe was immersed in the dummy water flowing in the circulation pipe, for 500 hours. After 500 hours elapsed, each of the test pieces A and B was detached from the circulation pipe, and the amount of Co-60 adhering to the test piece was measured.

Measurement results of the amount of adhering Co-60 to each of the test pieces are illustrated in Fig. 7. As clear from Fig. 7, in the test piece B in which platinum adhered to the surface of the nickel metal film, the amount of adhering Co-60 was significantly decreased in comparison to the test piece A in which the nickel metal film had not been formed and platinum adhered.

Results obtained in a manner that a composition on the surface of each of the test pieces A and B detached from the circulation pipe is analyzed by Raman spectrum are illustrated in Fig. 8. A film which had mainly been formed of Fe₃O₄ was formed on the surface of the test piece A which was substantially carbon steel. An oxide film having nickel ferrite (NiFe₂O₄) as the main component was formed on the surface of the test piece B in which the amount of adhering Co-60 was significantly reduced. The NiFe₂O₄ is a form in which x is 0 in Ni₁₋ₓFe₂₊ₓO₄.

Results of Auger spectrum on the surface of the test piece B detached from the circulation pipe are illustrated in Fig. 9. With the results illustrated in Fig. 9, it was confirmed that NiFe₂O₄ having a uniform composition was formed on the surface of a base material (carbon steel) of the test piece B. Forming NiFe₂O₄ causes the amount of adhering Co-60 to be significantly suppressed in the test piece B.

The reason that a nickel metal film of a carbon steel material (test piece B) in which the nickel metal film is formed on the surface thereof and noble metal (for example, platinum) adheres to the surface of the nickel metal film is brought into contact with water which includes an oxidant and has a temperature of 200°C or higher, and thus the nickel metal film is converted into a nickel ferrite film (nickel ferrite film in which x is 0 in Ni₁₋ₓFe₂₊ₓO₄) which covers the surface of the carbon steel material will be described. If the water which includes an oxidant and has a temperature of 200°C or higher is brought into contact with the nickel metal film on the carbon steel material, the nickel metal film and the carbon steel material are heated to 200°C or higher. Oxygen included in the water is transferred into the nickel metal film, and Fe included in the carbon steel material turns into Fe²⁺ and is transferred into the nickel metal film. Nickel in the nickel metal film reacts with oxygen and Fe²⁺ which are transferred into the nickel metal film in a high temperature environment of 200°C or higher, so as to generate nickel ferrite in which x is 0 in Ni₁₋ₓFe₂₊ₓO₄. A film of nickel ferrite covers the surface of the carbon steel material.

Regarding nickel ferrite which is generated, as described above, from nickel metal included in the nickel metal film covering the surface of the carbon steel material under a high temperature environment of 200°C or higher, and in which x is 0 in Ni₁₋ₓFe₂₊ₓO₄, crystal grows and becomes large. Even when noble metal adheres, nickel ferrite is not eluted and is stable in water, as in the Ni_{0.7}Fe_{2.3}O₄ film. Further, a radionuclide such as Co-60 is not taken in. Stable nickel ferrite in which x is 0 in Ni₁₋ₓFe₂₊ₓO₄ is generated in a manner that corrosion potentials of the carbon steel material and the nickel metal film are decreased by the action of the noble metal such as platinum, which adheres to the nickel metal film. As described above, the stable nickel ferrite film which covers the surface of the carbon steel material and is generated from nickel metal can restrain adhering of a radionuclide to the carbon steel material under a high temperature environment of 200°C or higher, for a term longer than the Ni_{0.7}Fe_{2.3}O₄ film generated in the low temperature range of 60°C to 100°C.

It was understood that chrome might be used instead of nickel, by the examination of the inventors. The nickel metal film was formed on the surface of the carbon steel material by bringing a film forming aqueous solution which included a nickel ion and a reductant into contact with the surface of the carbon steel material. However, the chrome metal film was formed on the surface of the carbon steel material by evaporating chrome to the surface of the carbon steel material because it was difficult to perform forming by bringing a film forming aqueous solution including a chrome ion and a reductant into contact with the surface of the carbon steel material. Noble metal (for example, platinum) adhered to the surface of the chrome metal film which had been formed on the surface of the carbon steel material by evaporation.

Further, water which includes an oxidant and has a temperature of 200°C or higher is brought into contact with the surface of the chrome metal film which has been formed on the surface of the carbon steel material and has noble metal adhering thereto, and thus the chrome metal film is converted into a chrome ferrite (FeCr₂O₄) film. Regarding chrome ferrite included in the chrome ferrite film, crystal grows and becomes larger. The chrome ferrite film is stable and is not eluted into the water even when the noble metal adheres. Similar to the above-described nickel ferrite film brought back from the nickel metal film, it is possible to restrain adhesion of a radionuclide to the carbon steel material for a long term.

The water which includes an oxidant and has a temperature of 200°C or higher is brought into contact with the chrome metal film formed on the surface of the carbon steel material, and thus it is possible to convert the chrome metal film into a chrome ferrite film which is stable and is not eluted even by an action of the adhering noble metal. However, the temperature of the water which includes an oxidant is preferably set in a range of 200°C to 330°C, in order to avoid an excessively high temperature from a viewpoint of being practical. In order to convert the above-described nickel metal film into a nickel ferrite film, the temperature of the water which is brought into contact with the nickel metal film, includes the oxidant, and is higher than 200°C is also preferably set to be in a range of 200°C to 330°C.

The inventors can create new two inventions of (1) and (2) which will be described below, based on the examination results described above.

(1) Either the nickel metal film or the chrome metal film is formed on the surface of the carbon steel material, which comes into contact with cooling water of the atomic energy plant, and noble metal is adhered to the surface of the formed metal film.

Preferably, the nickel metal film is formed on the surface of the carbon steel material in a manner that a film forming aqueous solution which includes a nickel ion and a reductant is brought into contact with the surface thereof before an atomic energy plant starts after an operation of the atomic energy plant is suspended. The chrome metal film is formed on the surface of the carbon steel material by evaporating chrome to the surface thereof before a newly-installed atomic energy plant starts.

(2) Either the nickel metal film or the chrome metal film is formed on the surface of the carbon steel material, which comes into contact with cooling water of an atomic energy plant. Noble metal is adhered to the surface of the formed metal film. Water which includes an oxidant and has a temperature range of 200°C to 330°C is brought into contact with either the nickel metal film having noble metal adhering thereto or the chrome metal film having noble metal adhering thereto. Either a nickel ferrite film which is converted from the nickel metal film in the temperature range or a chrome ferrite film which is converted from the chrome metal film in the temperature range is formed on the surface of the carbon steel material.

Preferably, the nickel metal film is formed on the surface of the carbon steel material in a manner that a film forming aqueous solution which includes a nickel ion and a reductant is brought into contact with the surface thereof before an atomic energy plant starts after an operation of the atomic energy plant is suspended. The chrome metal film is formed on the surface of the carbon steel material by evaporating chrome to the surface thereof before a newly-installed atomic energy plant starts.
(1) is the invention relating to an adhesion method of noble metal to a carbon steel material of an atomic energy plant. According to the invention of (1), the surface of the carbon steel material is covered with either the nickel metal film or the chrome metal film, and thus it is possible to prevent elution of Fe²⁺ from the carbon steel material and to reduce a time taken to adhere the noble metal to the surface of the carbon steel material.
(2) is the invention relating to an adhesion restraint method of a radionuclide to a carbon steel material of an atomic energy plant. According to the invention of (2), water which includes oxygen and has a temperature range of 200°C to 330°C is brought into contact with either the nickel metal film or the chrome metal film which are formed on the surface of the carbon steel material and have the noble metal adhering thereto, and either a nickel ferrite film which is converted from the nickel metal film in the temperature range or a chrome ferrite film which is converted from the chrome metal film in the temperature range is formed on the surface of the carbon steel material. Thus, it is possible to restrain adhesion of a radionuclide to the carbon steel material for a longer term (specifically, over a plurality (for example, 5) of operation cycles) without either the nickel ferrite film or the chrome ferrite film which have been formed being eluted into water even though the noble metal adheres to the nickel ferrite film and the chrome ferrite film.

Examples of the present invention, to which the above-described examination results have been applied will be described below.

### [Example 1]

An adhesion method of noble metal to a carbon steel material of an atomic energy plant according to Example 1 which is a preferred example of the present invention will be described with reference to Figs. 1 to 3. The adhesion method of noble metal to a carbon steel material of an atomic energy plant in this example is applied to a carbon steel purification system pipe (carbon steel material) of a boiling-water nuclear power plant (BWR plant) which has been operated in at least one operation cycle.

A schematic configuration of the BWR plant will be described with reference to Fig. 2. The BWR plant 1 includes a nuclear reactor 2, a turbine 9, a condenser 10, a recirculation system, a reactor purification system, a feedwater system, and the like. The nuclear reactor 2 includes a reactor pressure vessel (referred to as an RPV below) 3 which includes a reactor core 4 mounted therein. A jet pump 5 is installed in an annular downcomer which is formed between an outer surface of a core shroud (not illustrated) and an inner surface of the RPV 3. The core shroud surrounds the reactor core 4 in the RPV 3. Multiple fuel assemblies (not illustrated) are loaded on the reactor core 4. The fuel assembly includes a plurality of fuel rods filled with a plurality of fuel pellets which have been produced by a nuclear fuel material. The recirculation system includes a stainless-steel recirculation system pipe 6 and a recirculating pump 7 installed in the recirculation system pipe 6. The feedwater system is configured in a manner that a condensate pump 12, a condensate purification device (for example, condensate demineralizer) 13, a low pressure feedwater heater 14, a feedwater pump 15, and a high pressure feedwater heater 16 are installed from the condenser 10 toward the RPV 3 in a feedwater pipe 11 which connects the condenser 10 and the RPV 3 to each other, in this order. In the reactor purification system, a clean-up water pump 19, a regenerative heat exchanger 20, a non regenerative heat exchanger 21, and a reactor water purification device 22 are installed in a purification system pipe 18 which connects the recirculation system pipe 6 and the feedwater pipe 11 to each other, in this order. The purification system pipe 18 is connected to the recirculation system pipe 6 on the upstream of the recirculating pump 7. The nuclear reactor 2 is installed in a reactor containment vessel 87 disposed in a reactor building (not illustrated).

Cooling water (referred to as reactor water below) in the RPV 3 is pumped by the recirculating pump 7, and is ejected into the jet pump 5 through the recirculation system pipe 6. Reactor water which exists around a nozzle of the jet pump 5 in the downcomer is sucked into the jet pump 5, and is supplied to the reactor core 4. The reactor water supplied to the reactor core 4 is heated by heat generated in fission of the nuclear fuel material in the fuel rod. A portion of the heated reactor water turns into steam. The steam is guided to a turbine 9 from the RPV 3 through a main steam pipe 8, and rotates the turbine 9. A generator (not illustrated) joined to the turbine 9 rotates, and thus power is generated. Steam discharged from the turbine 9 is condensed by the condenser 10, and thus turns into water. The water passes through the feedwater pipe 11, as feedwater, and is supplied into the RPV 3. The feedwater flowing in the feedwater pipe 11 is pumped by the condensate pump 12. Impurities of the feedwater are removed in the condensate purification device 13, and then the feedwater is further pumped by the feedwater pump 15. The feedwater is heated by the low pressure feedwater heater 14 and the high pressure feedwater heater 16, and is guided into the RPV 3. Extraction steam which has been extracted from the turbine 9 in an extraction pipe 17 is supplied to each of the low pressure feedwater heater 14 and the high pressure feedwater heater 16, and functions as a heating source of the feedwater.

A portion of the reactor water flowing in the recirculation system pipe 6 flows into the purification system pipe 18 by driving the clean-up water pump 19. The reactor water flowing into the purification system pipe 18 is cooled by the regenerative heat exchanger 20 and the non regenerative heat exchanger 21, and then is purified in the reactor water purification device 22. The purified reactor water is heated in the regenerative heat exchanger 20, and is brought back into the RPV 3 via the purification system pipe 18 and the feedwater pipe 11.

In the adhesion method of noble metal to a carbon steel material of an atomic energy plant in this example, a film forming apparatus 30 is used, and the film forming apparatus 30 is connected to the purification system pipe 18 of a BWR plant, as illustrated in Fig. 2.

The detailed configuration of the film forming apparatus 30 will be described with reference to Fig. 3.

The film forming apparatus 30 includes a surge tank 31, circulating pumps 32 and 33, a circulation pipe 34, a nickel ion injection apparatus 35, a reductant injection apparatus 40, a platinum ion injection apparatus 45, a heater 51, a cooler 52, a cation exchange resin tank 53, a mixed resin deep bed demineralizer 54, a decomposition device 55, an oxidant supply unit 56, and an ejector 61.

A switching valve 62, the circulating pump 33, valves 63, 66, 68, and 73, the surge tank 31, the circulating pump 32, a valve 76, and a switching valve 77 are provided in the circulation pipe 34 in this order from an upstream. A pipe 65 configured to bypass the valve 63 is connected to the circulation pipe 34, and the valve 64 and a filter 50 are installed in the pipe 65. The cooler 52 and a valve 67 are installed in a pipe 98 which is configured to bypass the valve 66 and has both ends connected to the circulation pipe 34. The cation exchange resin tank 53 and a valve 69 are installed in a pipe 70 having both ends which are connected to the circulation pipe 34 so as to bypass the valve 68. The mixed resin deep bed demineralizer 54 and a valve 71 are installed in a pipe 72 having both ends which are connected to the pipe 70 so as to bypass the cation exchange resin tank 53 and the valve 69. The cation exchange resin tank 53 is filled with cation exchange resin, and the mixed resin deep bed demineralizer 54 is filled with cation exchange resin and anion exchange resin.

A valve 74 and a pipe 75 which is positioned on a downstream of the valve 74 bypass a valve 73, and are connected to the circulation pipe 34. In the pipe 75, the decomposition device 55 is installed. The decomposition device 55 is filled, for example, with an activated carbon catalyst in which ruthenium is attached to the surface of activated carbon. The surge tank 31 is installed in the circulation pipe 34 between the valve 73 and the circulating pump 32. The heater 51 is disposed in the surge tank 31. A pipe 79 in which a valve 78 and the ejector 61 are provided is connected to the circulation pipe 34 between a valve 76 and the circulating pump 32, and is further connected to the surge tank 31. A hopper (not illustrated) for supplying oxalic acid (deoxidizing decontamination agent) into the surge tank 31 is provided in the ejector 61. The oxalic acid is used for reducing and dissolving contaminants on an inner surface of the recirculation system pipe 6.

The nickel ion injection apparatus 35 includes a chemical liquid tank 36, an injection pump 37, and an injection pipe 38. The chemical liquid tank 36 is connected to the circulation pipe 34 by an injection pipe 38 which includes an injection pump 37 and a valve 39. The chemical liquid tank 36 is filled with a nickel formate aqueous solution (aqueous solution including nickel ions) in which nickel formate (2Ni (HCOO)·2H₂O) is dissolved in water.

The platinum ion injection apparatus (noble metal ion injection apparatus) 45 includes a chemical liquid tank 46, an injection pump 47, and an injection pipe 48. The chemical liquid tank 46 is connected to the circulation pipe 34 by an injection pipe 48 which includes the injection pump 47 and a valve 49. The chemical liquid tank 46 is filled with an aqueous solution including platinum ions (for example, sodium hexahydroxoplatinate hydrate aqueous solution), in which a platinum complex (for example, sodium hexahydroxoplatinate hydrate (Na₂[Pt(OH)₆]·nH₂O)) is dissolved and adjusted in water. The aqueous solution including the platinum ions is one kind of an aqueous solution including noble metal ions. As the aqueous solution including the noble metal ions, an aqueous solution including ions of any of palladium, rhodium, ruthenium, osmium, and iridium may be used in addition to the aqueous solution including the platinum ions.

The reductant injection apparatus 40 includes a chemical liquid tank 41, an injection pump 42, and an injection pipe 43. The chemical liquid tank 41 is connected to the circulation pipe 34 by the injection pipe 43 which includes the injection pump 42 and a valve 44. The chemical liquid tank 41 is filled with an aqueous solution of hydrazine which is a reductant. As the reductant, any of hydroxylamine and hydrazine derivatives such as hydrazine, form hydrazine, hydrazine carboxamide, and carbohydrazide may be used.

The injection pipes 38, 48, and 43 are connected to the circulation pipe 34 between the valve 76 and the switching valve 77 in an order from the valve 76 to the switching valve 77.

The oxidant supply unit 56 includes a chemical liquid tank 57, a supply pump 58, and a supply pipe 59. The chemical liquid tank 57 is connected to the pipe 75 on an upstream of the valve 74 by the supply pipe 59 which includes the supply pump 58 and a valve 60. The chemical liquid tank 57 is filled with hydrogen peroxide which is an oxidant. As the oxidant, water in which ozone or oxygen is dissolved may be used.

A pH meter 88 is attached to the circulation pipe 34 between a connection point (between the injection pipe 43 and the circulation pipe 34) and the switching valve 77.

The BWR plant 1 is suspended after an operation is ended in one operation cycle. After the operation suspension, some of the fuel assemblies loaded on the reactor core 4 are extracted as the used fuel assembly, and a new fuel assembly having fuel exposure of 0 GWd/t is loaded on the reactor core 4. After fuel exchange is ended as described above, the BWR plant 1 is restarted for an operation in the next operation cycle. Maintenance inspection of the BWR plant is performed by using a period when the BWR plant 1 is suspended for the fuel exchange.

As described above, the adhesion method of noble metal to a carbon steel material of an atomic energy plant in this example is performed in a period when an operation of the BWR plant 1 is suspended. The adhesion method is performed by using a carbon steel pipe system (for example, purification system pipe 18) which is one of carbon steel materials in the BWR plant 1 and communicates with the RPV 3, as a target. In the adhesion method of noble metal, forming a nickel metal film on an inner surface of the purification system pipe 18, which comes into contact with the reactor water, and adhesion treatment of noble metal, for example, platinum to the surface of the formed nickel metal film are performed.

The adhesion method of noble metal to a carbon steel material of an atomic energy plant in this example will be described below based on procedures illustrated in Fig. 1. In the adhesion method of noble metal to a carbon steel material of an atomic energy plant in this example, the film forming apparatus 30 is used.

Firstly, the film forming apparatus is connected to a carbon steel pipe system which is a film forming target (Step S1). When an operation of the BWR plant 1 is suspended, for example, a bonnet of a valve 23 opens so as to block the recirculation system pipe 6 side. The valve 23 is installed in the purification system pipe 18 (first pipe) connected to the recirculation system pipe 6. One end portion of the circulation pipe 34 (second pipe) of the film forming apparatus 30 on the switching valve 77 side is connected to flange of the valve 23. The one end portion of the circulation pipe 34 is connected to the purification system pipe 18 on an upstream side of the clean-up water pump 19. A bonnet of a valve 25 opens so as to block the non regenerative heat exchanger 21 side. The valve 25 is installed in the purification system pipe 18 between the regenerative heat exchanger 20 and the non regenerative heat exchanger 21. The other end portion of the circulation pipe 34 on the switching valve 62 side is connected to a flange of the valve 25. The other end portion of the circulation pipe 34 is connected to the purification system pipe 18 on a downstream side of the regenerative heat exchanger 20. Both of the ends of the circulation pipe 34 are connected to the purification system pipe 18 so as to form a closed loop which includes the purification system pipe 18 and the circulation pipe 34.

In this example, the film forming apparatus 30 is connected to the purification system pipe 18 of the reactor purification system. However, the film forming apparatus 30 may be connected to a carbon steel pipe of any of a residual heat removal system, a reactor core isolation cooling system, and a reactor core spray system which are carbon steel materials and communicate with the RPV 3, and the adhesion method of noble metal to a carbon steel material of an atomic energy plant in this example may be applied to the carbon steel pipe, in addition to the purification system pipe 18.

Chemical decontamination is performed on a carbon steel pipe system as a film forming target (Step S2). In the BWR plant 1 in which an operation has been performed in the previous operation cycle, an oxide film including a radionuclide is formed on the inner surface of the purification system pipe 18 which comes into contact with reactor water flowing from the RPV 3. Before a nickel metal film which will be described later is formed on the inner surface of the purification system pipe 18, the oxide film including a radionuclide is preferably removed from the inner surface thereof. When a film which includes nickel and has platinum adhering thereto is formed on the inner surface of the purification system pipe 18 by this example, the oxide film which has been formed on the inner surface of the purification system pipe 18 and includes a radionuclide is desirably removed in order to previously decrease a radiation dose rate of the purification system pipe 18, and to improve adhesive properties between the formed film and the inner surface of the purification system pipe 18. In order to remove the oxide film, chemical decontamination, in particular, deoxidizing decontamination using a deoxidizing decontamination aqueous solution which includes oxalic acid as a deoxidizing decontamination agent is performed on the inner surface of the purification system pipe 18.

Chemical decontamination applied to the inner surface of the purification system pipe 18 in Step S2 is known deoxidizing decontamination disclosed in JP-A-2000-105295. The deoxidizing decontamination will be described. Firstly, the circulating pumps 32 and 33 are driven in a state where each of the switching valve 62, the valves 63, 66, 68, 73, and 76, and the switching valve 77 are opened and other valves are closed. Thus, water heated by the heater 51 in the surge tank 31 in the purification system pipe 18 circulates in a closed loop formed by the circulation pipe 34 and the purification system pipe 18. The circulating water is adjusted to be 90°C by the heater 51. When the temperature of the water is 90°C, the valve 78 is opened so as to guide a portion of the water flowing in the circulation pipe 34 into the pipe 79. A predetermined amount of oxalic acid supplied from a hopper and the ejector 61 to the pipe 79 is guided into the surge tank 31 by the water flowing in the pipe 79. The oxalic acid is dissolved in water in the surge tank 31, and an oxalic acid aqueous solution (deoxidizing decontamination aqueous solution) is generated in the surge tank 31.

The oxalic acid aqueous solution is discharged from the surge tank 31 to the circulation pipe 34 by driving the circulating pump 32. A hydrazine aqueous solution in the chemical liquid tank 41 of the reductant injection apparatus 40 is injected into the oxalic acid aqueous solution in the circulation pipe 34 through the injection pipe 43 by opening the valve 44 and driving the injection pump 42. The injection pump 42 (or opening of the valve 44) is controlled based on a pH value of the oxalic acid aqueous solution, which has been measured by the pH meter 88 so as to adjust the amount of the hydrazine aqueous solution injected into the circulation pipe 34. Thus, pH of the oxalic acid aqueous solution supplied to the purification system pipe 18 is adjusted to be 2.5. In this example, hydrazine which is a reductant used when nickel metal is adhered to the inner surface of the purification system pipe 18 and when noble metal, for example, platinum is adhered onto the film of nickel metal is used as a pH regulator for adjusting pH of the oxalic acid aqueous solution in a process of deoxidizing decontamination.

The oxalic acid aqueous solution having pH of 2.5 and a temperature of 90°C is supplied to the purification system pipe 18 from the circulation pipe 34, and is brought into contact with the oxide film which has been formed on the inner surface of the purification system pipe 18 and includes a radionuclide. The oxide film is dissolved by oxalic acid. The oxalic acid aqueous solution flows in the purification system pipe 18 with dissolving the oxide film. The oxalic acid aqueous solution passes through the clean-up water pump 19 and the regenerative heat exchanger 20 and is brought back to the circulation pipe 34. The oxalic acid aqueous solution brought back to the circulation pipe 34 is pumped by the circulating pump 33 through the switching valve 62, and reaches the surge tank 31. In this manner, the oxalic acid aqueous solution circulates in the closed loop which includes the circulation pipe 34 and the purification system pipe 18, and performs deoxidizing decontamination of the inner surface of the purification system pipe 18. Thus, the oxalic acid aqueous solution dissolves the oxide film formed on the inner surface thereof.

Radionuclide concentration and Fe concentration of the oxalic acid aqueous solution are increased with dissolving the oxide film. Water is caused to pass through the cation exchange resin tank 53 in order to suppress an increase of concentration of each of a radionuclide and Fe which are included in the oxalic acid aqueous solution. That is, the valve 69 is opened, the opening of the valve 68 is adjusted, and thus a portion of the oxalic acid aqueous solution brought back to the circulation pipe 34 is guided to the cation exchange resin tank 53 through the pipe 70. The radionuclide and metal cations such as Fe, which are included in the oxalic acid aqueous solution are absorbed and removed to the cation exchange resin in the cation exchange resin tank 53. The oxalic acid aqueous solution discharged from the cation exchange resin tank 53 and the oxalic acid aqueous solution passing through the valve 68 are supplied again to the purification system pipe 18 from the circulation pipe 34, and are used in deoxidizing decontamination of the purification system pipe 18.

In deoxidizing decontamination which is performed on the surface of the carbon steel material (for example, purification system pipe 18) by using oxalic acid, oxalic acid iron (II) which is poorly soluble is formed on the surface of the carbon steel material. With the oxalic acid iron (II), dissolution of the oxide film formed on the surface of the carbon steel material by oxalic acid may be suppressed. In this case, the valve 68 is totally opened, and the valve 69 is closed so as to suspend a supply of the oxalic acid aqueous solution to the cation exchange resin tank 53. Hydrogen peroxide which is an oxidant is injected into the oxalic acid aqueous solution flowing in the circulation pipe 34. The hydrogen peroxide is injected into the oxalic acid aqueous solution in a manner that the valve 60 is opened so as to start the supply pump 58, and hydrogen peroxide in the chemical liquid tank 57 passes through the supply pipe 59 and the pipe 75. At this time, the valve 74 is closed. The oxalic acid aqueous solution which includes hydrogen peroxide is guided into the purification system pipe 18 from the circulation pipe 34. Fe(II) included in oxalic acid iron (II) which has been formed on the inner surface of the purification system pipe 18 is oxidized to be Fe(III) by an action of hydrogen peroxide included in the oxalic acid aqueous solution. The oxalic acid iron (II) is dissolved in the oxalic acid aqueous solution, as an oxalic acid iron (III) complex. That is, oxalic acid iron (II), and hydrogen peroxide and oxalic acid which are included in the oxalic acid aqueous solution generates an oxalic acid iron (III) complex, water, and hydrogen ions by a reaction represented by Formula (1).

2Fe(COO)₂+H₂O₂+2(COOH)₂ → 2Fe[(COO)₂]₂⁻+2H₂O+2H⁺ ... (1)

It is confirmed that oxalic acid iron (II) formed on the inner surface of the purification system pipe 18 is dissolved, and hydrogen peroxide injected into the oxalic acid aqueous solution is eliminated by the reaction of Formula (1). Then, the valve 69 is opened, and the opening of the valve 68 is adjusted. A portion of the oxalic acid aqueous solution which has flowed in the circulation pipe 34 and passed through the valve 66 is supplied to the cation exchange resin tank 53 through the pipe 70. The metal cations such as a radionuclide, which are included in the oxalic acid aqueous solution are absorbed and removed to the cation exchange resin in the cation exchange resin tank 53. Losing hydrogen peroxide in the oxalic acid aqueous solution can be confirmed in a manner that test paper which reacts with hydrogen peroxide is put into the oxalic acid aqueous solution subjected to sampling from the circulation pipe 34, and a color appearing in test paper is viewed.

When the radiation dose rate at a deoxidizing decontamination location of the purification system pipe 18 is performed is decreased up to a set radiation dose rate, or when a deoxidizing decontamination period of the purification system pipe 18 reaches a predetermined period, oxalic acid and hydrazine included in the oxalic acid aqueous solution are decomposed. That is, a deoxidizing decontamination agent decomposition process is performed. Decreasing the radiation dose rate at the deoxidizing decontamination location up to the set radiation dose rate can be confirmed by a radiation dose rate which has been obtained based on an output signal of a radiation detector configured to detect radiations from the deoxidizing decontamination location of the purification system pipe 18.

The oxalic acid and the hydrazine are decomposed in the following manner. The valve 74 is opened, and the opening of the valve 73 is slightly reduced. The oxalic acid aqueous solution which has flowed in the circulation pipe 34, passed through the valve 68, and includes hydrazine is supplied to the decomposition device 55 by the pipe 75 through the valve 74. At this time, the valve 60 is opened so as to drive the supply pump 58, and thus hydrogen peroxide in the chemical liquid tank 57 is supplied to the pipe 75 through the supply pipe 59, and flows into the decomposition device 55. Oxalic acid and hydrazine included in the oxalic acid aqueous solution are decomposed in the decomposition device 55 by an action of the activated carbon catalyst and the supplied hydrogen peroxide. A decomposition reaction of the oxalic acid and the hydrazine in the decomposition device 55 is represented by Formula (2) and Formula (3).

(COOH)₂+H₂O₂ → 2CO₂+2H₂O... (2)

N₂H₄+2H₂O₂ → N₂+4H₂O ... (3)

The oxalic acid and the hydrazine are decomposed in the decomposition device 55 while the oxalic acid aqueous solution circulates in the closed loop which includes the circulation pipe 34 and the purification system pipe 18. The amount of hydrogen peroxide supplied to the decomposition device 55 from the chemical liquid tank 57 is adjusted by controlling a rotation speed of the supply pump 58 such that the supplied hydrogen peroxide is totally consumed in the decomposition device 55 because of decomposition of the oxalic acid and the hydrazine, and do not flow out from the decomposition device 55.

In the deoxidizing decontamination decomposition process, if oxalic acid exists in the oxalic acid aqueous solution, oxalic acid iron (II) may be formed on the inner surface of the purification system pipe 18 which is a carbon steel material and comes into contact with the oxalic acid aqueous solution. Thus, the rotation speed of the supply pump 58 is increased at a stage at which decomposing oxalic acid and hydrazine which are included in the oxalic acid aqueous solution proceeds to a certain extent. Thus, the amount of hydrogen peroxide supplied to the decomposition device 55 from the chemical liquid tank 57 is increased so as to elute hydrogen peroxide from the decomposition device 55.

The oxalic acid aqueous solution which has been discharged from the decomposition device 55 and includes hydrogen peroxide is guided to the purification system pipe 18 from the circulation pipe 34. As described above, oxalic acid iron (II) formed on the inner surface of the purification system pipe 18 which is a carbon steel material turns into an oxalic acid iron (III) complex by the action of the hydrogen peroxide, and is dissolved in the oxalic acid aqueous solution. Since decomposing oxalic acid and the like in the oxalic acid aqueous solution has proceeded, oxalic acid required for converting Fe(II) included in oxalic acid iron (II) into Fe(III) which is easily dissolved is insufficient. Thus, Fe(OH)₃ is easily precipitated on the inner surface of the circulation pipe 34. Thus, in order to suppress precipitation of Fe (OH)₃, formic acid is injected into the oxalic acid aqueous solution. Formic acid is injected, for example, in a manner that formic acid is supplied to the oxalic acid aqueous solution from the hopper and the ejector 61 which are described above, and is guided to the surge tank 31 in a state where the valve 78 is opened and the oxalic acid aqueous solution flows into the pipe 79. The supplied formic acid is mixed with the oxalic acid aqueous solution.

The oxalic acid aqueous solution which includes the supplied formic acid includes hydrogen peroxide discharged from the decomposition device 55, in addition to oxalic acid and hydrazine having decreased concentration. The oxalic acid aqueous solution which includes formic acid and hydrogen peroxide is supplied to the purification system pipe 18. Hydrogen peroxide included in the oxalic acid aqueous solution dissolves oxalic acid iron (II) precipitated to the inner surface of the purification system pipe 18. Formic acid dissolves Fe(OH)₃. The oxalic acid aqueous solution circulates in the closed loop which includes the circulation pipe 34 and the purification system pipe 18. Thus, decomposition of oxalic acid and hydrazine continues in the decomposition device 55.

Then, in order to end the decomposition process of oxalic acid, hydrogen peroxide concentration of the oxalic acid aqueous solution flowing in the circulation pipe 34 is decreased, and the oxalic acid aqueous solution is supplied to the cation exchange resin tank 53. Thus, the valve 60 is closed, and the valve 78 is closed for suspending injection of formic acid. If injection of hydrogen peroxide and formic acid to the oxalic acid aqueous solution flowing in the circulation pipe 34 is suspended, concentration of hydrogen peroxide and formic acid in the oxalic acid aqueous solution is also decreased. When hydrogen peroxide concentration of the oxalic acid aqueous solution is equal to or less than 1 ppm, the valve 69 is opened, the opening of the valve 68 is reduced, and the oxalic acid aqueous solution is supplied to the cation exchange resin tank 53. As described above, metal cations included in the oxalic acid aqueous solution are removed by cation exchange resin in the cation exchange resin tank 53, and metal cation concentration of the oxalic acid aqueous solution is decreased. Decomposition of oxalic acid, hydrazine, and formic acid in the decomposition device 55 continues. Among the oxalic acid, the hydrazine, and the formic acid, the hydrazine is decomposed for the first time, the oxalic acid is decomposed next, and formic acid finally remains. The decomposition process of oxalic acid is ended in this state.

When chemical decontamination described above is ended, the oxide film including a radionuclide is removed from the inner surface of the purification system pipe 18, and the purification system pipe 18 is in a state illustrated in Fig. 4. The inner surface of the purification system pipe 18 is brought into contact with an aqueous solution which includes the remaining formic acid as described above.

The temperature of a film forming liquid is adjusted (Step S3). The valves 68 and 73 are opened and the valves 69 and 74 are closed. Since the circulating pumps 32 and 33 drive, the aqueous solution which includes the remaining formic acid circulates in the closed loop which includes the circulation pipe 34 and the purification system pipe 18. The aqueous solution which includes formic acid is heated up to 90°C by the heater 51. It is desirable that the temperature of the formic acid aqueous solution (film forming aqueous solution which will be described later) is set to be in a range of 60°C to 100°C. Further, the valve 64 is opened, and the valve 63 is closed. The valves are operated, and thus the formic acid aqueous solution flowing in the circulation pipe 34 is supplied to the filter 50, and a fine solid content which remains in the formic acid aqueous solution is removed by the filter 50. In a case where the fine solid content is not removed by the filter 50, when the nickel metal film is formed on the inner surface of the purification system pipe 18, when the nickel formic acid aqueous solution has been injected into the circulation pipe 34, the nickel metal film is also formed on the surface of the solid matter, and the injected nickel ions are wastefully used. The formic acid aqueous solution is supplied to the filter 50 in order to prevent such wasteful use of nickel ions.

The nickel ion aqueous solution is injected (Step S4) . The valve 63 is opened, the valve 64 is closed, and water passing through the filter 50 is suspended. The valve 39 in the nickel ion injection apparatus 35 is opened, and the injection pump 37 drives. The nickel formate aqueous solution in the chemical liquid tank 36 is injected into an aqueous solution of 90°C, which includes the remaining formic acid, and flows in the circulation pipe 34 through the injection pipe 38. Nickel ion concentration of the injected nickel formate aqueous solution is, for example, 200 ppm.

The reductant is injected (Step S5). The valve 44 of the reductant injection apparatus 40 is opened and the injection pump 42 drives. An aqueous solution of hydrazine which is a reductant in the chemical liquid tank 41 is injected into an aqueous solution of 90°C, which includes nickel ions and formic acid, and flows in the circulation pipe 34 through the injection pipe 43. Hydrazine concentration of the injected hydrazine aqueous solution is, for example, 200 ppm. The amount of the hydrazine aqueous solution injected into the aqueous solution is adjusted to cause pH of the aqueous solution of 90°C, which includes nickel ions and formic acid to be in a range of 4.0 to 11.0, for example, to be 4.0.

An aqueous solution which includes nickel ions, formic acid, and hydrazine and has pH of 4.0 and a temperature of 90°C, that is, the film forming aqueous solution (film forming liquid) is supplied to the purification system pipe 18 from the circulation pipe 34 by driving the circulating pump 32. The film forming aqueous solution 83 is brought into contact with the inner surface of the purification system pipe 18, and thus the nickel metal film 80 is formed on the inner surface of the purification system pipe 18 (see Fig. 5). The nickel metal film 80 is formed in a manner as follows. The inner surface of the purification system pipe 18 and the film forming aqueous solution 83 having pH of 4.0 come into contact with each other, and thus a substitution reaction between a nickel ion included in the film forming aqueous solution 83 and an Fe (II) ion in the purification system pipe 18 is accelerated, and the amount of nickel ions taken in the inner surface of the purification system pipe 18 becomes large, and the amount of iron (II) ions eluted to the film forming aqueous solution 83 is increased. Nickel ions taken in the inner surface of the purification system pipe 18 turn into nickel metal by the action of hydrazine included in the film forming aqueous solution 83. Thus, the nickel metal film 80 is formed on the inner surface of the purification system pipe 18.

When pH of the film forming aqueous solution 83 coming into contact with the inner surface of the purification system pipe 18 is 4.0, the substitution reaction of the nickel ion and the iron (II) ion is most activated, and the amount of nickel ions taken in the inner surface of the purification system pipe 18 is largest. If pH of the film forming aqueous solution 83 becomes larger (for example, 7) by injecting the reductant, the amount of the taken nickel ions turning into nickel metal is increased.

Thus, the aqueous solution of 90°C, which is generated by injecting the nickel formate aqueous solution and the hydrazine aqueous solution in Steps S4 and S5, includes nickel ions, formic acid, and hydrazine, and has pH of, for example, 4 is supplied to the purification system pipe from the circulation pipe 34 and is brought into contact with the inner surface of the purification system pipe 18. Thus, the substitution reaction of the nickel ion and the iron (II) ion on the inner surface of the purification system pipe 18 is accelerated. After that, in a certain period, the hydrazine aqueous solution may be further injected into the circulation pipe 34 in Step S5, and the aqueous solution (film forming aqueous solution) of 90°C, which includes nickel ions, formic acid, and hydrazine, and has pH, for example, of 7.0 may be supplied into the purification system pipe 18. Thus, the nickel ion taken into the surface of the purification system pipe 18 by the substitution reaction may be converted into nickel metal. Thus, forming the nickel metal film on the inner surface of the purification system pipe 18 is accelerated.

The film forming aqueous solution 83 discharged from the purification system pipe 18 to the circulation pipe 34 is pumped by the circulating pumps 33 and 32. Each of the nickel formate aqueous solution and the hydrazine aqueous solution is injected, and is injected into the purification system pipe 18 again. As described above, the film forming aqueous solution 83 is circulated in the closed loop which includes the circulation pipe 34 and the purification system pipe 18, and thus the nickel metal film uniformly covers the entire surface of the inner surface of the purification system pipe 18, which comes into contact with the film forming aqueous solution 83. At this time, nickel metal on the inner surface of the purification system pipe 18 is 50 µg per 1 square centimeter (50 µg/cm²).

It is determined whether forming the nickel metal film is completed (Step S6) . In a case where the nickel metal film 80 formed on the inner surface of the purification system pipe 18 is insufficient (in a case where nickel metal on the inner surface is less than 50 µg/cm²), each of the processes of Steps S4 to S6 is repeated. When nickel metal on the inner surface of the purification system pipe 18 is 50 µg/cm², the injection pump 37 is suspended and the valve 39 is closed. Thus, injection of the nickel formate aqueous solution to the circulation pipe 34 is suspended, the injection pump 42 is suspended, and the valve 44 is closed. Injection of the hydrazine aqueous solution into the circulation pipe 34 is suspended, and forming the nickel metal film on the inner surface of the purification system pipe 18 is ended. When a time elapsing from when the nickel formate aqueous solution is injected into the circulation pipe 34 is a set time, it is determined that nickel metal on the inner surface of the purification system pipe 18 is 50 µg/cm². The set time is obtained in a manner that a time until nickel metal on the surface of a carbon steel test piece is 50 µg/cm² is measured in advance.

The reductant is decomposed (Step S7). The valve 74 is opened and a portion of the opening of the valve 73 is closed. A portion of the film forming aqueous solution 83 pumped by the circulating pump 33 is guided to the decomposition device 55 through the pipe 75. Further, hydrogen peroxide in the chemical liquid tank 57 is supplied to the decomposition device 55 through the supply pipe 59 and the pipe 75. Hydrazine which is included in the film forming aqueous solution 83 and is the reductant is decomposed into nitrogen and water by the action of the activated carbon catalyst and the hydrogen peroxide in the decomposition device 55.

The film forming aqueous solution in which the reductant is decomposed is purified (Step S8). After the hydrazine (reductant) is decomposed, the valve 73 is opened and the valve 74 is closed. Thus, a supply of the film forming aqueous solution 83 which does not include hydrazine to the decomposition device 55 is suspended. Then, the valve 67 is opened, the valve 66 is closed, and the valve 71 is opened. A portion of the opening of the valve 68 is closed. At this time, the valve 69 is closed, and the circulating pumps 33 and 32 drive. The film forming aqueous solution 83 which is brought back to the circulation pipe 34 from the purification system pipe 18 and does not include hydrazine is cooled up to 60°C in the cooler 52. Further, the film forming aqueous solution 83 is guided to the mixed resin deep bed demineralizer 54, and nickel ions, other cations, and other anions which remain in the film forming aqueous solution 83 are absorbed and removed to the cation exchange resin and the anion exchange resin in the mixed resin deep bed demineralizer 54 (first purification) . The film forming aqueous solution of 60°C, which does not include hydrazine is circulated in the circulation pipe 34 and the purification system pipe 18 until each of the above ions does not exist substantially. The film forming aqueous solution in which each of the above ions does not exist substantially becomes water of 60°C.

The platinum ion aqueous solution is injected (Step S9) . After the first purification process is ended, the valve 68 is opened, the valve 71 is closed, and the valve 49 is opened. Thus, the injection pump 47 is driven. Water flowing in the circulation pipe 34 is maintained to be 60°C by heating of the heater 51. The aqueous solution including platinum ions (for example, aqueous solution of sodium hexahydroxoplatinate hydrate (Na₂[Pt(OH)₆]·nH₂O)) in the chemical liquid tank 46 is injected into the water of 60°C through the injection pipe 48. Concentration of platinum ions of the injected aqueous solution is, for example, 1 ppm. In the aqueous solution of sodium hexahydroxoplatinate hydrate, platinum is in an ion state. The aqueous solution of 60°C, which includes platinum ions is supplied to the purification system pipe 18 from the circulation pipe 34, and is brought back to the circulation pipe 34 from the purification system pipe 18 by driving the circulating pumps 32 and 33. The aqueous solution including the platinum ions circulates in the closed loop which includes the circulation pipe 34 and the purification system pipe 18.

Just after injection starts, an injection rate of the aqueous solution of Na₂[Pt(OH)₆]·nH₂O to the circulation pipe 34 is previously calculated such that platinum concentration of the aqueous solution (which is injected into the circulation pipe 34 from the chemical liquid tank 46 through a connection point between the circulation pipe 34 and the injection pipe 48) of Na₂[Pt(OH)₆]·nH₂O at a connection point is setting concentration, for example, 1 ppm. Further, concentration of platinum ions in the water of 60°C, which flows in the circulation pipe 34 is set as the setting concentration. The amount of the aqueous solution of Na₂[Pt(OH)₆]·nH₂O, which is required for attaching a predetermined amount of platinum to the surface of the nickel metal film formed on the inner surface of the purification system pipe 18 and with which the chemical liquid tank 46 is filled is calculated. The chemical liquid tank 46 is filled with the calculated amount of the aqueous solution of Na₂[Pt(OH)₆]·nH₂O. The rotation speed of the injection pump 47 is controlled to match with the injection rate of the calculated amount of the aqueous solution of Na₂Pt(OH)₆]·nH₂O to the circulation pipe 34. The aqueous solution of Na₂[Pt(OH)₆]·nH₂O in the chemical liquid tank 46 is injected into the circulation pipe 34.

The reductant is injected (Step S10). Similar to Step S5, the aqueous solution of hydrazine which is the reductant in the chemical liquid tank 41 is injected into the aqueous solution of 60°C, which includes platinum ions in the circulation pipe 34 through the injection pipe 43. Hydrazine concentration of the injected hydrazine aqueous solution is, for example, 100 ppm.

The hydrazine aqueous solution is injected into the circulation pipe 34 after the aqueous solution of Na₂[Pt(OH)₆]·nH₂O of 60°C reaches a connection point between the injection pipe 43 and the circulation pipe 34, which is an injection point of the hydrazine aqueous solution. In this case, an aqueous solution 84 of 60°C, which includes platinum ions and hydrazine is supplied to the purification system pipe 18 from the circulation pipe 34. However, more preferably, just after a predetermined amount of the aqueous solution of Na₂[Pt(OH)₆]·nH₂O, with which the chemical liquid tank 46 is filled is totally injected into the circulation pipe 34, and the injection is ended, the hydrazine aqueous solution is desirably injected into the circulation pipe 34. In this case, the aqueous solution of 60°C, which includes platinum ions is supplied to the purification system pipe 18 from the circulation pipe 34. After the injection of the platinum ion aqueous solution into the circulation pipe 34 is ended, the aqueous solution 84 (see Fig. 6) of 60°C, which includes platinum ions and hydrazine is supplied to the purification system pipe 18 from the circulation pipe 34.

In the former case where the hydrazine aqueous solution is injected, a reduction reaction in which platinum ions turn into platinum by hydrazine firstly occurs in the aqueous solution 84 flowing in the circulation pipe 34. On the contrary, in the latter case where the hydrazine aqueous solution is injected, platinum ions are already absorbed to the surface of the nickel metal film 80 formed on the inner surface of the purification system pipe 18, and the absorbed platinum ions are reduced by the hydrazine. Thus, the amount of platinum 81 adhered to the surface of the nickel metal film 80 formed on the inner surface of the purification system pipe 18 is further increased (see Fig. 6).

Just after the hydrazine aqueous solution is injected, the injection rate of the hydrazine aqueous solution to the circulation pipe 34 is previously calculated such that hydrazine concentration of the hydrazine aqueous solution (which is injected from the chemical liquid tank 41 through a connection point between the circulation pipe 34 and the injection pipe 43) at the connection point is setting concentration, for example, 100 ppm. Further, concentration of hydrazine in the aqueous solution of 60°C, which flows in the circulation pipe 34 and includes platinum ions is set as the setting concentration. The amount of the hydrazine aqueous solution with which the chemical liquid tank 41 is filled, and which is required for reducing platinum ions absorbed to the surface of the nickel metal film 80 formed on the inner surface of the purification system pipe 18 to be platinum 81 is calculated, and the chemical liquid tank 41 is filled with the calculated amount of the hydrazine aqueous solution. The rotation speed of the injection pump 42 is controlled to match with the injection rate of the calculated amount of the hydrazine aqueous solution to the circulation pipe 34. The hydrazine aqueous solution in the chemical liquid tank 41 is injected into the circulation pipe 34.

When the aqueous solution (aqueous solution including platinum ions) of Na₂[Pt(OH)₆]·nH₂O in the chemical liquid tank 46 is totally injected into the circulation pipe 34, driving of the injection pump 47 is suspended and the valve 49 is closed. Thus, injection of the aqueous solution including platinum ions to the circulation pipe 34 is suspended. When the hydrazine aqueous solution (reductant aqueous solution) in the chemical liquid tank 41 is totally injected into the circulation pipe 34, driving of the injection pump 42 is suspended and the valve 44 is closed. Thus, injection of the hydrazine aqueous solution to the circulation pipe 34 is suspended.

The platinum ions absorbed to the surface of the nickel metal film 80 are reduced by the hydrazine and turn into platinum 81. Thus, the platinum 81 is adhered to the surface of the nickel metal film 80 formed on the inner surface of the purification system pipe 18 (see Fig. 6).

It is determined whether adhering of platinum is completed (Step S11). When a time elapsing from injection of the platinum ion aqueous solution and the reductant aqueous solution reaches a predetermined time, it is determined that adhering of a predetermined amount of platinum to the surface of the nickel metal film 80 formed on the inner surface of the purification system pipe 18 is completed. When the elapsing time does not reach the predetermined time, each of the process of Steps S9 to S11 is repeated.

As disclosed in Example 3 (Figs. 10 to 12) in JP-A-2014-44190, a crystal vibrating electrode device is installed in the circulation pipe 34 on an upstream side of the circulating pump 33, and the crystal vibrating electrode device measures that the predetermined amount of platinum adheres to the surface of the nickel metal film 80 formed on the inner surface of the purification system pipe 18. The crystal vibrating electrode device is configured as follows. Crystal is attached to a cavity formed in an electrode holder. A carbon steel metal member (same as the composition of the purification system pipe 18) is attached to the surface of the crystal on an opened end side of the electrode holder. The surface of the crystal between the metal member and the electrode holder is covered with a sealing member. Such an electrode holder is disposed in the circulation pipe 34, and the surface of the metal member is brought into contact with the film forming aqueous solution 83 which flows in the circulation pipe 34 and is described above. The nickel metal film 80 is formed on the surface of the metal member which is in contact with the film forming aqueous solution 83. After the determination in the process of Step S6 is "YES", the aqueous solution 84 of 60°C, which includes platinum ions and hydrazine is supplied to the purification system pipe 18 from the circulation pipe 34 and is brought back to the circulation pipe 34. Then, the aqueous solution 84 is brought into contact with the nickel metal film 80 formed on the surface of the metal member provided in the electrode holder which has been disposed in the circulation pipe 34. Thus, the platinum 81 is adhered to the surface of the nickel metal film 80. The crystal vibrates by applying a voltage to the crystal. Thus, the metal member on which the nickel metal film 80 having the platinum 81 adhering thereto also vibrates along with the crystal. The frequency of the crystal which includes the metal member is measured by a frequency measuring device, and is decreased by an extent of the platinum 81 adhering. A difference between a frequency before the platinum 81 is adhered and a frequency after the platinum 81 is adhered, that is, the weight of the platinum 81 adhering to the surface of the nickel metal film 80 is obtained based on the frequency measured by the frequency measuring device. When the obtained weight is a setting weight, it is determined that a predetermined amount of the platinum 81 is adhered to the surface of the nickel metal film 80 formed on the inner surface of the purification system pipe 18.

In Step S6, similarly, the determination of whether forming the nickel metal film 80 on the inner surface of the purification system pipe 18 is completed may be performed based on the frequency of the crystal including the metal member, which is measured by the frequency measuring device. The weight of the nickel metal film 80 formed on the inner surface of the purification system pipe 18 is a difference between a frequency before the nickel metal film 80 is formed on the surface of the metal member and a frequency after the film 80 is formed, and the weight of the nickel metal film 80 is obtained based on the measured frequency of the crystal. When the weight of the nickel metal film 80 is a setting weight, it is determined that nickel metal included in the nickel metal film 80 formed on the inner surface of the purification system pipe 18 is 50 µg/cm².

The aqueous solution remaining in the purification system pipe 18 and the circulation pipe 34 is purified (Step S12). After it is determined that adhering of the platinum 81 to the surface of the nickel metal film 80 formed on the inner surface of the purification system pipe 18 is completed, the valve 71 is opened and a portion of the opening of the valve 68 is closed. The aqueous solution 84 pumped by the circulating pump 33 is supplied to the mixed resin deep bed demineralizer 54. Platinum ions, other metal cations (for example, sodium ions), the hydrazine, and OH groups which are included in the aqueous solution 84 are absorbed to ion exchange resin in the mixed resin deep bed demineralizer 54 and are removed from the aqueous solution (second purification).

Waste liquid is treated (Step S13). After the second purification process is ended, the circulation pipe 34 is connected to a waste liquid treatment device (not illustrated) by a high pressure hose (not illustrated) including a pump (not illustrated) . After the second purification process is ended, the aqueous solution which remains in the purification system pipe 18 and the circulation pipe 34 and is a radioactive waste liquid is discharged to the waste liquid treatment device (not illustrated) from the circulation pipe 34 through the high pressure hose by driving the pump, and is treated in the waste liquid treatment device. After the aqueous solution in the purification system pipe 18 and the circulation pipe 34 is discharged, washing water is supplied into the purification system pipe 18 and the circulation pipe 34. The circulating pumps 32 and 33 drive, and the insides of the pipes are washed. After the washing is ended, the washing water in the purification system pipe 18 and the circulation pipe 34 is discharged to the waste liquid treatment device.

With the above descriptions, the adhesion method of noble metal to a carbon steel material of an atomic energy plant in the example is ended. The film forming apparatus 30 connected to the purification system pipe 18 is detached from the purification system pipe 18, and the purification system pipe 18 is restored.

In this example, forming the nickel metal film 80 which covers the inner surface of the purification system pipe 18, and adhering noble metal (for example, platinum 81) to the surface of the nickel metal film 80 can be performed by using the film forming apparatus 30. The forming and the adhering can be performed in an operation suspension period of the BWR plant 1 before the BWR plant 1 starts in the next operation cycle.

According to this example, the nickel metal film 80 which covers the inner surface of the purification system pipe 18 is formed on the inner surface thereof, which is brought into contact with reactor water. Thus, it is possible to prevent elution of Fe²⁺ to the aqueous solution 84 flowing in the purification system pipe 18 from the purification system pipe 18. A case where adhesion of noble metal (for example, platinum) to the inner surface of the purification system pipe 18 is hindered by elution of Fe²⁺ does not occur, and it is possible to reduce a time taken to adhere noble metal to the inner surface thereof (specifically, adhere noble metal to the surface of the nickel metal film 80 formed on the inner surface of the purification system pipe 18). It is possible to adhere noble metal to the inner surface thereof with high efficiency, and the amount of the noble metal adhering to the inner surface of the purification system pipe 18 is increased.

In this example, nickel metal of 50 µg/cm² is provided in the nickel metal film 80 formed on the inner surface of the purification system pipe 18. As described above, if the nickel metal of 50 µg/cm² is provided, the nickel metal film 80 is in a state of covering the entire surface of the inner surface of the purification system pipe 18, which is brought into contact with the film forming aqueous solution. The nickel metal film 80 blocks contact of the reactor water flowing in the purification system pipe 18 with a base material of the purification system pipe 18 after the BWR plant starts in the next operation cycle. Thus, a radionuclide included in the reactor water is not taken into the base material of the purification system pipe 18.

The nickel metal film 80 formed on the inner surface of the purification system pipe 18 causes a time taken to adhere platinum to the purification system pipe 18 to be reduced. In addition, as will be described in Examples 2 and 3 which will be described later, a decrease of corrosion potentials of the purification system pipe 18 and the nickel metal film 80 by the adhering platinum 81 is reduced. Thus, the nickel metal film 80 contributes to forming of a stable nickel ferrite film which is not eluted to the reactor water even by the adhering platinum, on the inner surface of the purification system pipe 18.

The nickel ion included in the film forming aqueous solution is substituted with an iron ion included in the purification system pipe 18, and is taken into the inner surface of the purification system pipe 18. Thus, the nickel ion taken into the inner surface is reduced by the hydrazine (reductant) included in the film forming aqueous solution and forms nickel metal. As described above, the nickel metal generated from the nickel ion taken into the purification system pipe 18 by the substitution reaction, by the action of the reductant has significantly strong adhesive properties to the base material of the purification system pipe 18. Thus, the nickel metal film 80 is not left from the purification system pipe 18.

In this example, after the inner surface of the purification system pipe 18 is subjected to deoxidizing decontamination, the nickel metal film 80 is formed on the inner surface of the purification system pipe 18. Thus, the nickel metal film is not formed on the oxide film which has been formed on the inner surface of the purification system pipe 18 and includes a radionuclide. Radiations emitted from the purification system pipe 18 are reduced, and the surface radiation dose rate of the purification system pipe 18 is significantly reduced.

When the inner surface of the purification system pipe 18 is subjected to deoxidizing decontamination by using the oxalic acid aqueous solution and when oxalic acid is decomposed, oxalic acid iron (II) formed on the inner surface of the purification system pipe 18 which is the carbon steel material is removed by the action of the oxidant (for example, hydrogen peroxide) injected into the oxalic acid aqueous solution. The oxalic acid iron (II) is removed, and thus it is possible to improve adhesive properties between the purification system pipe 18 and the nickel metal film 80, and to prevent loss of the nickel metal film 80 from the inner surface of the purification system pipe 18.

### [Example 2]

An adhesion restraint method of a radionuclide to a carbon steel material of an atomic energy plant according to Example 2 which is another preferred example of the present invention will be described below with reference to Figs. 10 and 11. The adhesion restraint method of a radionuclide to a carbon steel material of an atomic energy plant in this example is applied to a purification system pipe of a BWR plant which has been operated in at least one operation cycle.

In the adhesion restraint method of a radionuclide to a carbon steel material of an atomic energy plant in this example, the processes of Steps S1 to S13 in the adhesion method of noble metal to a carbon steel material of an atomic energy plant in Example 1, and new processes of Steps S14 to S17 are performed. In the adhesion restraint method of a radionuclide to a carbon steel material of an atomic energy plant in this example, the film forming apparatus 30 used in Example 1 is used in each of the processes of Steps S1 to S13, and a new heating system 90 is used in each of the processes of Steps S15 and S16.

The configuration of the heating system 90 will be described with reference to Fig. 11. The heating system 90 has a pressure-resistant structure, and includes a circulation pipe 91, a circulating pump 92, a heater 93, and a valve 94 which is a pressure boosting device. The circulating pump 92 is provided in the circulation pipe 91, and the heating device 93 is provided in the circulation pipe 91 on an upstream of the circulating pump 92. The heating device 93 may be disposed on a downstream of the circulating pump 92. The pipe 95 bypasses the circulating pump 92. One end portion of the pipe 95 is connected to the circulation pipe 91 on an upstream of the circulating pump 92. Another end portion of the pipe 95 is connected to the circulation pipe 91 on a downstream of the circulating pump 92. The valve 94 is provided in the pipe 95. A switching valve 96 is provided on an end portion of the circulation pipe 91 on an upstream side thereof, and a switching valve 97 is provided on an end portion of the circulation pipe on a downstream side thereof.

The film forming apparatus is removed from the pipe system (Step S14). In the adhesion restraint method of a radionuclide to a carbon steel material in this example, after the processes of Steps S1 to S13 are performed, the film forming apparatus 30 connected to the purification system pipe 18 is detached from the purification system pipe 18. One end portion of the circulation pipe 34 in the film forming apparatus 30 is detached from the flange of the valve 23, and another end portion of the circulation pipe 34 is detached from the flange of the valve 25.

The heating system is connected to the pipe system (Step S15). One end portion of the circulation pipe 91 (third pipe) of the heating system 90 on the switching valve 97 side is connected to the flange of the valve 23, and is connected to the purification system pipe 18 on an upstream side of the clean-up water pump 19. Another end portion of the circulation pipe 91 on the switching valve 96 side is connected to the flange of the valve 25, and is connected to the purification system pipe 18 between the regenerative heat exchanger 20 and the non regenerative heat exchanger 21. Both ends of the circulation pipe 91 are connected to the purification system pipe 18, so as to form a closed loop which includes the purification system pipe 18 and the circulation pipe 91.

Water which has a temperature of 200°C or higher and includes oxygen is brought into contact with the nickel metal film to which platinum is adhered (Step S16). The closed loop including the circulation pipe 91 and the purification system pipe 18 is filled with the water including oxygen which is the oxidant. Instead of the water including oxygen, water including hydrogen peroxide which is the oxidant or water including oxygen and hydrogen peroxide may be used. The circulating pump 92 is driven, and thus the water including oxygen is circulated in the closed loop. The rotation speed of the circulating pump 92 is increased up to a certain rotation speed. Then, the opening of the valve 94 is gradually decreased, and thus pressure of water discharged from the circulating pump 92 is increased. The heater 93 heats the water which circulates in the closed loop and includes oxygen, and increases the temperature of the water. As described above, while the pressure of the water discharged from the circulating pump 92 is increased, the temperature of the water is increased. After the valve 94 is totally closed, the rotation speed of the circulating pump 92 is further increased. With such an operation, the pressure of the water circulating in the closed loop is increased up to, for example, 1.6 MPa, and the temperature of the water is increased up to about 201°C. The pressure and the temperature of the water circulating in the closed loop are held to the above values, respectively. If the pressure of the water circulating in the closed loop is increased up to 6 MPa, the temperature of the water can be increased up to about 276°C by the heater 93.

Water 85 which includes oxygen and has a temperature of about 201°C is supplied to the purification system pipe 18 from the circulation pipe 91, and is brought into contact with the nickel metal film 80 which has been formed on the inner surface of the purification system pipe 18, and to which the platinum 81 adheres (see Fig. 13). The purification system pipe 18 is surrounded by an insulator (not illustrated) except for the vicinity of the valves 23 and 25 to which both of the end portions of the circulation pipe 91 are connected respectively. The water 85 of about 201°C is brought into contact with the nickel metal film 80, and thus each of the purification system pipe 18 and the nickel metal film 80 is heated, and the temperature of each of the purification system pipe 18 and the nickel metal film 80 is about 201°C.

Each of the water 85 including oxygen, the purification system pipe 18, and the nickel metal film 80 has a temperature of about 201°C which is equal to or higher than 200°C. Oxygen (O₂) which is an oxidant included in the water 85 and oxygen constituting some water molecules which are included in the water 85 of about 201°C are transferred into the nickel metal film 80. Fe included in the purification system pipe 18 turns into Fe²⁺, and is transferred into the nickel metal film 80 (see Fig. 14). Oxygen constituting some water molecules which are included in the water 85 easily moves individually in the water 85 of 200°C or higher, and is easily inserted into the nickel metal film 80. With the action of the platinum 81 adhering to the nickel metal film 80, the corrosion potentials of the purification system pipe 18 and the nickel metal film 80 are decreased. The decrease of the corrosion potential of the nickel metal film 80 and the forming in a high temperature environment of about 201°C cause oxygen after nickel in the nickel metal film 80 is transferred into the nickel metal film 80 (oxidant included in the water 85 and oxygen constituting some water molecules of the water 89) to react with Fe²⁺, and nickel ferrite (NiFe₂O₄) in which x is 0 in Ni₁₋ₓFe₂₊ₓO₄ is generated. Thus, the nickel metal film 80 formed on the inner surface of the purification system pipe 18 is converted into the film 82 of nickel ferrite, and the nickel ferrite film 82 covers the inner surface of the purification system pipe 18 (see Fig. 15). The nickel ferrite film 82 covers the entire surface of the inner surface of the purification system pipe 18, which has been covered by the nickel metal film 80. The platinum 81 adheres onto the nickel ferrite film 82. The generated nickel ferrite in which x is 0 in Ni₁₋ₓFe₂₊ₓO₄ is generated under a high temperature environment of about 201°C, and thus crystal is larger than that of the Ni_{0.7}Fe_{2.3}O₄.

The heating system is detached from the pipe system (Step S17). After the nickel ferrite film 82 is formed to cover the inner surface of the purification system pipe 18, the heating system 90 connected to the purification system pipe 18 is detached from the purification system pipe 18. One end portion of the circulation pipe 91 of the heating system 90 is detached from the flange of the valve 23, and another end portion of the circulation pipe 91 is detached from the flange of the valve 25. Then, the purification system pipe 18 is restored.

After fuel exchange and maintenance inspection of the BWR plant 1 are ended, in order to start an operation in the next operation cycle, the BWR plant 1 including the purification system pipe 18 which has an inner surface on which the nickel ferrite film 82 having the platinum 81 adhering thereto is formed is started. The reactor water flowing in the purification system pipe 18 is not directly brought into contact with the base material of the purification system pipe 18 because the nickel ferrite film 82 is formed.

This example can obtain the effects in Example 1.

Further, as described above, a film 82 of nickel ferrite in which x is 0 in Ni₁₋ₓFe₂₊ₓO₄ is generated from the nickel metal film 80 under a high temperature environment of about 201°C which is equal to or higher than 200°C, in a state where the platinum 81 adhering to the nickel metal film 80 causes the corrosion potentials of the purification system pipe 18 and the nickel metal film 80 to be decreased. The film 82 of the nickel ferrite is a stable nickel ferrite film which is not eluted into the reactor water by the action of the adhering platinum 81 even in the operation of the BWR plant 1. The stable nickel ferrite film 82 which has been generated in this manner and is not eluted into the reactor water even by the action of the adhering platinum 81 can restrain adhesion of a radionuclide to the purification system pipe 18 for a term which is longer than that of the Ni_{0.7}Fe_{2.3}O₄ film generated in a low temperature range of 60°C to 100°C. Specifically, the stable nickel ferrite film 82 which has been formed on the inner surface of the purification system pipe 18 can restrain adhesion of a radionuclide to the purification system pipe 18 over a plurality of operation cycles, for example, 5 operation cycles (for example, 5 years). Thus, it is possible to reduce the number of performing chemical decontamination on the purification system pipe 18.

As described above, the adhesive properties between the nickel metal film 80 and the base material of the purification system pipe 18 is significantly strong. Thus, the adhesive properties between the nickel ferrite film 82 generated in this example and the base material of the purification system pipe 18 is also significantly strong. The nickel ferrite film 82 is not left from the purification system pipe 18.

In this example, forming the nickel metal film 80 on the inner surface of the purification system pipe 18 and adhering the platinum 81 to the nickel metal film 80 are performed in a period when an operation of the BWR plant 1 is suspended after an operation of the BWR plant 1 is suspended and before the BWR plant 1 restarts. Further, conversion of the nickel metal film 80 into the nickel ferrite film 82 is also performed in the period when the operation of the BWR plant 1 is suspended. Thus, as in Example 3 which will be described later, nickel included in the nickel metal film 80 is not eluted to the reactor water when the BWR plant 1 starts. It is possible to restrain adhesion of a radionuclide to the purification system pipe 18 by the nickel ferrite film 82 to which the platinum 81 adheres, when the BRW plant 1 operates until a nuclear reactor output reaches 100%.

In a case where the platinum is directly adhered to the inner surface of the purification system pipe 18, in order to suppress an occurrence of stress corrosion cracking in a stainless-steel component (for example, recirculation system pipe 6), hydrogen is injected into the reactor water in the RPV 3 when the BWR plant operates. However, if the reactor water including hydrogen flows into the purification system pipe 18 and is brought into contact with the inner surface of the carbon steel purification system pipe 18, the corrosion potential of the purification system pipe 18 is increased by the action of the platinum adhered to the inner surface of the purification system pipe 18. As a result, the oxide film is formed on the inner surface of the purification system pipe 18 and a radionuclide included in the reactor water is taken into the oxide film. Thus, the surface radiation dose rate of the purification system pipe 18 is increased.

On the contrary, in this example, even when hydrogen is injected into the reactor water when the BWR plant 1 operates, the action of the platinum 81 adhered to the nickel ferrite film 82 causes the corrosion potentials of the purification system pipe 18 and the nickel ferrite film 82 to be decreased. Thus, a radionuclide is not taken into the purification system pipe 18 and the nickel ferrite film 82.

### [Example 3]

An adhesion restraint method of a radionuclide to a carbon steel material of an atomic energy plant according to Example 3 which is still another preferred example of the present invention will be described below with reference to Fig. 12. The adhesion restraint method of a radionuclide to a carbon steel material of an atomic energy plant in this example is applied to a purification system pipe of a BWR plant which has been operated in at least one operation cycle.

In the adhesion restraint method of a radionuclide to a carbon steel material of an atomic energy plant in this example, the processes of Steps S1 to S13 in the adhesion method of noble metal to a carbon steel material of an atomic energy plant in Example 1, and new processes of Steps S14, S18, and S19 are performed. In the adhesion restraint method of a radionuclide to a carbon steel material of an atomic energy plant in this example, the film forming apparatus 30 used in Example 1 is used in each of the processes of Steps S1 to S13. Further, the adhesion restraint method of a radionuclide to a carbon steel material of an atomic energy plant in this example is a method in which the processes of Steps S15 to S17 in the adhesion restraint method of a radionuclide to a carbon steel material in Example 2 are replaced with the processes of S18 and S19.

The film forming apparatus is removed from the pipe system (Step S14). After the processes of Steps S1 to S13 are performed, similar to Example 2, the film forming apparatus 30 is detached from the purification system pipe 18, and the purification system pipe 18 is restored.

The atomic energy plant is started (Step S18). After fuel exchange and maintenance inspection of the BWR plant 1 are ended, in order to start an operation in the next operation cycle, the BWR plant 1 including the purification system pipe 18 which has an inner surface on which the nickel metal film 80 is formed is started.

Reactor water of 200°C or higher is brought into contact with the nickel metal film to which platinum adheres (Step S19) . When the BWR plant 1 is started, as described above, the reactor water in the downcomer of the RPV 3 is supplied to the reactor core 4 through the recirculation system pipe 6 and the jet pump 5. The reactor water discharged from the reactor core is brought back to the downcomer. A control rod (not illustrated) is pulled from the reactor core 4 and the reactor core 4 is in a critical state from a not-critical state. The reactor water in the reactor core 4 is heated by heat generated in the fission of the nuclear fuel material in the fuel rod. In the reactor core 4, steam is not generated. The control rod is pulled from the reactor core 4. In a temperature rising and pressing process of the nuclear reactor 2, pressure in the RPV 3 is increased to rated pressure. The reactor water is heated by heat generated in the fission, and the temperature of the reactor water in the RPV 3 is increased to a rated temperature (280°C). After the pressure in the RPV 3 is the rated pressure and the temperature of the reactor water is increased to the rated temperature, the control rod is pulled further from the reactor core 4 and the flow rate of the reactor water supplied to the reactor core 4 is increased. Thus, the nuclear reactor output is increased to rated power (100% output). A rated operation of the BWR plant 1 in which the rated power is maintained continues until the operation cycle is ended. When the nuclear reactor output is increased, for example, to 10% output, steam generated in the reactor core 4 is supplied to the turbine 9 through the main steam pipe 8 and power generation is started.

The reactor water 86 includes oxygen and hydrogen peroxide. Oxygen and hydrogen peroxide are generated by radiation decomposition of the reactor water 86 in the RPV 3. The reactor water 86 in the RPV 3 is guided into the purification system pipe 18 from the recirculation system pipe 6, and is brought into contact with the nickel metal film 80 which has been formed on the inner surface of the purification system pipe 18 and to which the platinum 81 adheres (see Fig. 13). In a temperature rising and pressing process of the nuclear reactor 2, the reactor water is heated by heat generated in the above-described fission. The temperature of the reactor water 86 which comes into contact with the nickel metal film 80 is increased, becomes 200°C or higher, and is increased up to 280°C at the rated power. If the temperature of the reactor water 86 is equal to or higher than 200°C, the temperature of each of the nickel metal film 80 and the purification system pipe 18 surrounded by a heat insulator is also equal to or higher than 200°C. As a result, oxygen which is the oxidant included in the reactor water 86 and oxygen constituting some of water molecules included in the reactor water 86 of 200°C or higher are transferred into the nickel metal film 80. Fe included in the purification system pipe 18 turns into Fe²⁺, and is transferred into the nickel metal film 80 (see Fig. 14). Oxygen constituting some of water molecules included in the reactor water 90 also easily moves individually in the reactor water 90 of 200°C or higher, and is easily inserted into the Ni_{0.7}Fe_{2.3}O₄ film 85. The decrease of the corrosion potential of each of the purification system pipe 18 and the nickel metal film 80 and forming in a high temperature environment of about 200°C or higher by the action of the platinum 81 adhering to the nickel metal film 80 cause oxygen after nickel in the nickel metal film 80 is transferred (oxidant included in the reactor water 86 and oxygen constituting some water molecules of the reactor water 86) to react with Fe²⁺, and nickel ferrite (NiFe₂O₄) in which x is 0 in Ni₁₋ₓFe₂₊ₓO₄ is generated.

Thus, the nickel metal film 80 formed on the inner surface of the purification system pipe 18 is converted into the film 82 of nickel ferrite, and the nickel ferrite film 82 covers the inner surface of the purification system pipe 18 (see Fig. 15). The nickel ferrite film 82 covers the entire surface of the inner surface of the purification system pipe 18, which has been covered by the nickel metal film 80. The platinum 81 adheres onto the nickel ferrite film 82.

This example can obtain the effects in Example 2. As in Example 2, in this example, a connection work of the heating system 90 to the purification system pipe 18 after the film forming apparatus 30 is detached from the purification system pipe 18, and a detachment work of the heating system 90 from the purification system pipe 18 after the nickel ferrite film 82 is formed on the inner surface of the purification system pipe 18 are not required. After the film forming apparatus 30 is detached from the purification system pipe 18, the BWR plant 1 only starts, and thus it is possible to convert the nickel metal film 80 which is formed on the inner surface of the purification system pipe 18 and has the platinum 81 adhering thereto, into the nickel ferrite film 82 to which the platinum 81 adheres. Thus, it is possible to reduce a time taken to form the nickel ferrite film 82 on the inner surface of the purification system pipe 18, by a time which is obtained by not performing the works of connection of the heating system 90 to the purification system pipe 18 and detachment of the heating system 90 from the purification system pipe 18, in comparison to Example 2.

In this example, forming the nickel metal film 80 on the inner surface of the purification system pipe 18 and adhering the platinum 81 to the nickel metal film 80 are performed in a period when the operation of the BWR plant 1 is suspended, similar to Example 2. However, conversion of the nickel metal film 80 into the nickel ferrite film 82 is performed after the BWR plant 1 starts, differently from Example 2. Thus, in a state where the temperature of the reactor water is lower than 200°C, the nickel metal film 80 is not converted into the nickel ferrite film 82, and the inner surface of the purification system pipe 18 is covered by the nickel metal film 80 to which the platinum 81 adheres (see Fig. 13). Even in this state, the action of the platinum 81 causes the corrosion potential of the nickel metal film 80 brought into contact with the reactor water 86, further, the corrosion potential of each of the purification system pipe 18 and the nickel metal film 80 to be decreased, and a radionuclide is not taken into the nickel metal film 80 and the purification system pipe 18. In this manner, adhesion of a radionuclide to the purification system pipe 18 is restrained.

In the state where the reactor water 86 comes into contact with the nickel metal film 80, nickel which is very little included in the nickel metal film 80 is eluted into the reactor water 86. If a period when the reactor water 86 is in contact with the nickel metal film 80 becomes long, for example, over a period of one operation cycle, the nickel metal film 80 may be lost. However, in this example, if the temperature of the reactor water 86 is equal to or higher than 200°C in the temperature rising and pressing process when the BWR plant 1 starts, as described above, the nickel metal film 80 which has the platinum 81 adhering thereto and is in contact with the reactor water 86 is converted into the nickel ferrite film 82. Thus, the stable nickel ferrite film 82 which is not eluted even by the action of the platinum 81 covers the inner surface of the purification system pipe 18 in almost of the operation cycle. Accordingly, adhesion of a radionuclide to the purification system pipe 18 is restrained by the nickel ferrite film 82. A period when the nickel metal film 80 covers the inner surface of the purification system pipe 18 and the temperature of the reactor water 86 is lower than 200°C is a very short period in one operation cycle. Thus, the amount of nickel eluted from the nickel metal film 80 to the reactor water 86 is very small, and the thickness of the nickel metal film 80 is hardly changed.

In Examples 2 and 3, adhesion of a radionuclide to the inner surface of the purification system pipe 18 is restrained by the nickel ferrite film 82 formed on the inner surface of the purification system pipe 18. However, an operation of the BWR plant 1 in a plurality of operation cycles causes a radionuclide of a very small amount in each of the operation cycle to adhere to the inner surface of the purification system pipe 18 and to be accumulated. Thus, for example, after an operation of the BWR plant 1 over 5 operation cycles (5 years) is ended, the film forming apparatus 30 is connected to the purification system pipe 18 of the BWR plant 1 in the period when the operation of the BWR plant 1 is suspended (Step S1). Deoxidizing decontamination is performed on the purification system pipe 18, and the nickel ferrite film 82 to which the radionuclides adhere is removed (Step S2).

Further, the processes of Steps S3 to S14, and S18 and S19 in the adhesion restraint method of a radionuclide in Example 3 are performed on the purification system pipe 18 in which deoxidizing decontamination is performed and the nickel ferrite film 82 is removed. As a result, the nickel ferrite film 82 having a surface to which the platinum 81 adheres is formed on the inner surface of the purification system pipe 18. In a state where the nickel ferrite film 82 is formed, the BWR plant 1 is operated without performing deoxidizing decontamination, over the next 5 operation cycle, for example. The processes of Steps S3 to S17 in the adhesion restraint method of a radionuclide in Example 2 may be performed on the purification system pipe 18 in which deoxidizing decontamination is performed and the nickel ferrite film 82 is removed.

### [Example 4]

An adhesion restraint method of a radionuclide to a carbon steel material of an atomic energy plant according to Example 4 which is still another preferred example of the present invention will be described below with reference to Figs. 16 and 17. The adhesion restraint method of a radionuclide to a carbon steel material of an atomic energy plant in this example is applied to a purification system pipe of a new-installed BWR plant which has not been operated in one operation cycle.

The adhesion restraint method of a radionuclide to a carbon steel material of an atomic energy plant in this example is a method in which the processes of Steps S1 to S8 and S14 in the adhesion restraint method of a radionuclide to a carbon steel material of an atomic energy plant in Example 3 are replaced with the processes of Steps S20 to S22 and S14A. In the adhesion restraint method of a radionuclide to a carbon steel material of an atomic energy plant in this example, the processes of Steps S9 to S13, and S18 and S19 performed in the adhesion restraint method of a radionuclide to a carbon steel material of an atomic energy plant in Example 3 are also performed.

Here, the processes of Steps S20 to S22 and S14A will be mainly described.

Chrome is evaporated to the inner surface of a carbon steel pipe, so as to form a chrome metal film on the inner surface thereof (Step S20). A boiling point of chrome is 2671°C. A crucible into which chrome has been put is heated so as to melt chrome in the crucible. If the temperature of the melted chrome exceeds 2671°C, steam of the chrome is generated. The generated steam of the chrome is guided into a carbon steel pipe which is used in the purification system pipe 18 being the carbon steel material, and is a straight pipe. Chrome is evaporated over the entirety of the inner surface of the pipe. As a result, the chrome metal film which covers the entirety of the inner surface and has a predetermined thickness is formed on the entirety of the inner surface of the pipe. Similarly, chrome is also evaporated to an inner surface of a carbon steel curved pipe which is used in a curved portion of the purification system pipe 18, so as to form a chrome metal film which covers the entirety of the inner surface and has a predetermined thickness. The chrome metal film having a predetermined thickness includes chrome metal at a proportion of 50 µg/cm². The pipe and the curved pipe having an inner surface to which chrome is evaporated is carbon steel pipe constituents.

The chrome metal film may be formed on the inner surface of a carbon steel pipe constituent (straight pipe and curved pipe) by plating instead of evaporation.

A plurality of pipes having an inner surface on which the chrome metal film has been formed is connected to each other so as to form a purification system pipe of an atomic energy plant (Step S21). When a new-installed BWR plant 1 is built before a first operation such as a test operation starts, the plurality of pipes having an inner surface on which the chrome metal film has been formed in Step S20 and a curved pipe are connected to each other by welding, so as to form the purification system pipe 18 of the atomic energy plant 1. The purification system pipe 18 (see Fig. 18) which is formed by connection in this manner and has an inner surface on which a chrome metal film 80A is formed is connected to the valve 23 and the valve 25 illustrated in Fig. 2, and is at least disposed between the valve 23 and the valve 25. The purification system pipe 18 communicates with the recirculation system pipe 6, and also communicates with the non regenerative heat exchanger 21. The clean-up water pump 19, the valve 24, and the regenerative heat exchanger 20 are provided in the purification system pipe 18 having an inner surface on which the chrome metal film 80A has been formed.

The noble metal injection apparatus is connected to a pipe system as a noble metal injection target (Step S22). The noble metal injection apparatus 30A illustrated in Fig. 17 is connected to the purification system pipe 18 formed in Step S21. Specifically, similar to the connection of the film forming apparatus 30 to the purification system pipe 18 (first pipe) in Step S1 in Example 1, one end portion of the circulation pipe 34 (second pipe) of the noble metal injection apparatus 30A on the switching valve 77 side is connected to the flange of the valve 23, and is connected to the purification system pipe 18 on an upstream side of the clean-up water pump 19. Another end portion of the circulation pipe 34 on the switching valve 62 side is connected to the flange of the valve 25 and is connected to the purification system pipe 18 on a downstream side of the regenerative heat exchanger 20. Thus, a closed loop which includes the circulation pipe 34 of the noble metal injection apparatus 30A and the purification system pipe 18 is formed. The noble metal injection apparatus 30A has a configuration in which the nickel ion injection apparatus 35 is removed from the above-described film forming apparatus 30.

Then, injection of the aqueous solution including a platinum ion into the circulation pipe 34 in Step S9 and injection of the hydrazine aqueous solution into the circulation pipe 34 in Step S10 are performed. The aqueous solution 84 of 60°C, which includes platinum ions and hydrazine is supplied to the purification system pipe 18 from the circulation pipe 34. The aqueous solution 84 is brought into contact with the surface of the chrome metal film 80A formed on the inner surface of the purification system pipe 18 (see Fig. 18), and platinum ions included in the aqueous solution 84 are absorbed to the surface of the chrome metal film 80A. Hydrazine which is a reductant included in the aqueous solution 84 causes the platinum ions absorbed to the surface of the chrome metal film 80A to be reduced, and thus the platinum ions forms the platinum 81. As a result, the platinum 81 is adhered to the surface of the chrome metal film 80A (see Fig. 19).

When the determination in Step S11 is "YES", the processes of Step S12 (purification) and S13 (waste liquid treatment) are sequentially performed. The processes of Steps S22 and S9 to S13 are performed before the first operation is started in a new-installed BWR plant 1.

The noble metal injection apparatus is removed from the pipe system (Step S14A). After the process of Step S13 is performed, the noble metal injection apparatus 30A is detached from the purification system pipe 18 and the purification system pipe 18 is restored. Then, the start (Step S18) of the new-installed BWR plant 1, and contact (Step S19) (see Fig. 20) of the reactor water 86 of 200°C or higher with the chrome metal film 80A to which platinum is adhered are separately performed.

The BWR plant 1 is started, and the reactor water 86 of 200°C or higher is brought into contact with the surface of the chrome metal film 80A on the inner surface of the purification system pipe 18, to which the platinum 81 is adhered. The contact of the reactor water 86 having a temperature of 200°C or higher causes each of oxygen which is an oxidant included in the reactor water 86 and oxygen constituting some water molecules which are included in the reactor water 86 of 200°C or higher, and Fe²⁺ from the purification system pipe 18 to be transferred into the chrome metal film 80A (see Fig. 21) . The decrease of the corrosion potential of each of the purification system pipe 18 and the chrome metal film 80A and forming in a high temperature environment of about 200°C or higher by the action of the adhering platinum 81 cause oxygen after chrome in the chrome metal film 80A is transferred to react with Fe²⁺, and chrome ferrite (FeCr₂O₄) is generated. As a result, the inner surface of the purification system pipe 18 is covered by the chrome ferrite film 82A having a surface to which the platinum 81 adheres (see Fig. 22). The BWR plant 1 continues an operation in one operation cycle after the start, in a state where the inner surface of the purification system pipe 18 is covered by the chrome ferrite film 82A having a surface to which the platinum 81 adheres.

In this example, the processes of Steps S20 to S22, S9 to S13, and S14A are performed before the first operation of the BWR plant 1 starts, that is, when the BWR plant 1 is suspended.

According to this example, the chrome metal film 80A for covering the inner surface of the purification system pipe 18, which is brought into contact with the reactor water is formed on the inner surface thereof. Thus, it is possible to prevent elution of Fe²⁺ from the purification system pipe 18 to the aqueous solution including a platinum ion. In addition, similar to Example 1, it is possible to reduce a time taken to adhere noble metal (for example, platinum) to the inner surface of the purification system pipe 18 is reduced. It is possible to adhere noble metal to the inner surface thereof with high efficiency, and the amount of the noble metal adhering to the inner surface of the purification system pipe 18 is increased.

The chrome metal film for covering the inner surface of the purification system pipe 18 is formed by evaporation. Thus, the chrome metal film has strong adhesive properties to the purification system pipe 18, and is not left from the purification system pipe 18. The chrome metal film is formed on the inner surface of the purification system pipe 18 of a newly-installed BWR plant 1. Thus, as in Examples 1 to 3, it is not necessary that the purification system pipe 18 is subjected to deoxidizing decontamination before the chrome metal film is formed.

In this example, in a state where the corrosion potentials of the purification system pipe 18 and the chrome metal film 80A are decreased by the action of the platinum 81 adhering to the chrome metal film 80A, and under a high temperature environment of 200°C or higher, as described above, the chrome ferrite film 82A generated from the chrome metal film 80A is a stable chrome ferrite film which is not eluted into the reactor water by the action of the adhering platinum 81 even in the period when the BWR plant 1 operates . The chrome ferrite film 82A which covers the inner surface of the purification system pipe 18 can restrain adhesion of a radionuclide to the purification system pipe 18 for a long term, specifically, for a plurality of operation cycles, for example, over 5 operation cycles (for example, 5 years). Thus, it is possible to reduce the number of performing chemical decontamination on the purification system pipe 18. The chrome ferrite film 82A is also not left from the purification system pipe 18.

In this example, even when hydrogen is injected into the reactor water when the BWR plant 1 operates, the action of the platinum 81 adhered to the chrome ferrite film 82A causes the corrosion potentials of the purification system pipe 18 and the chrome ferrite film 82A to be decreased. Thus, a radionuclide is not taken into the purification system pipe 18 and the chrome ferrite film 82A.

In this example, the chrome metal film 80A is converted into the chrome ferrite film 82A by starting the BWR plant 1. Thus, as in Example 2, the works of connection of the heating system 90 to the purification system pipe 18 and detachment of the heating system 90 from the purification system pipe 18 are not necessary, and thus a time to taken to form the chrome ferrite film 82A is reduced. Further, in a period from the BWR plant 1 starts until the chrome ferrite film 82A is formed on the inner surface of the purification system pipe 18, it is possible to restrain adhesion of a radionuclide to the purification system pipe 18 by the chrome metal film 80A.

In this example, the purification system pipe 18 is formed in a manner that a straight pipe and a curved pipe which are plurality of carbon steel pipe constituents and have an inner surface on which the chrome metal film is formed by evaporation are connected to each other by welding. Thus, in the formed purification system pipe 18, the chrome metal film 80A is not formed on the inner surface of a welding portion of the straight pipe and a curved pipe. Thus, the chrome ferrite film 82A is not formed on the inner surface of the welding portion, and a radionuclide adheres to the inner surface of the welding portion when the BWR plant 1 operates. The amount of a radionuclide adhering to the purification system pipe 18 is increased in comparison to Examples 2 and 3 in which the nickel ferrite film 82 is formed on the inner surface of the purification system pipe 18. However, a proportion of the length of a portion of the purification system pipe 18, at which the chrome ferrite film 82A has been formed to the total length of the purification system pipe is much greater than a proportion of the total length of all welding portions between the valve 23 and the valve 25 to the total length of the purification system pipe 18 between the valve 23 and the valve 25. Thus, the adhesion restraint effect of a radionuclide to the inner surface of the purification system pipe 18 by the chrome ferrite film 82A is large.

Instead of the adhesion restraint method of a radionuclide to a carbon steel material of an atomic energy plant in this example, an adhesion restraint method of a radionuclide, in which the processes of Steps S1 to S8 and S14 in the adhesion restraint method of a radionuclide to a carbon steel material in Example 2 are replaced with the processes of Steps S20 to S22 and S14A may be performed.

Adhesion of a radionuclide to the inner surface of the purification system pipe 18 is restrained by the chrome ferrite film 82A. However, similar to a case where the nickel ferrite film 82 is formed on the inner surface of the purification system pipe 18, a radionuclide of a very small amount adheres to the inner surface of the purification system pipe 18 and is accumulated over a plurality of operation cycles. Thus, for example, after an operation for 5 operation cycle is ended, deoxidizing decontamination is performed on the purification system pipe 18 in a period when an operation of the BWR plant 1 is suspended (Steps S1 and S2 which are described above are performed). The deoxidizing decontamination causes the chrome ferrite film 82A to which a radionuclide adheres to be removed from the inner surface of the purification system pipe 18. Then, in the period when the operation is suspended, the processes of Steps S3 to S17 in Example 2 or the processes of Steps S3 to S14, S18, and S19 in Example 3 are performed, and thus the nickel ferrite film 82 having a surface to which the platinum 81 adheres is formed on the inner surface of the purification system pipe 18. The reason of forming the nickel ferrite film 82 after the deoxidizing decontamination is because that it is not possible that chrome adheres to the inner surface of the purification system pipe 18 which communicates with the RPV 3, by the evaporation.

Each of Examples 1 to 4 can be applied to a carbon steel material of a pressurized-water nuclear power plant and a Canada type heavy water cooling pressure pipe type nuclear power plant, which is brought into contact with the reactor water.

### Reference Signs List

1 BOILING-WATER NUCLEAR POWER PLANT
2 REACTOR PRESSURE VESSEL
4 REACTOR CORE
6 RECIRCULATION SYSTEM PIPE
9 TURBINE
11 FEEDWATER PIPE
18 PURIFICATION SYSTEM PIPE
30 FILM FORMING APPARATUS
30A NOBLE METAL INJECTION APPARATUS
31 SURGE TANK
32, 33, 92 CIRCULATING PUMP
34, 91 CIRCULATION PIPE
35 NICKEL ION INJECTION APPARATUS
36, 41, 46, 57 CHEMICAL LIQUID TANK
37, 42, 47 INJECTION PUMP
40 REDUCTANT INJECTION APPARATUS
45 PLATINUM ION INJECTION APPARATUS
51, 93 HEATER
52 COOLER
53 CATION EXCHANGE RESIN TANK
54 MIXED RESIN DEEP BED DEMINERALIZER
55 DECOMPOSITION DEVICE
56 OXIDANT SUPPLY UNIT
58 SUPPLY PUMP
80 NICKEL METAL FILM
81 PLATINUM
82 NICKEL FERRITE FILM
90 HEATING SYSTEM

## Claims

1. An adhesion method of noble metal to a carbon steel material of an atomic energy plant, the method comprising:
forming either a nickel metal film (80) or a chrome metal film on a surface of the carbon steel material of the atomic energy plant, which comes into contact with cooling water, so as to cover the surface with the formed metal film; and
adhering noble metal to the surface of the formed metal film,
wherein the forming of either the nickel metal film (80) or the chrome metal film, and the adhering of the noble metal are performed when the atomic energy plant is suspended.

2. The adhesion method of noble metal to a carbon steel material of an atomic energy plant according to Claim 1,
wherein nickel metal contained in the nickel metal film is provided on the surface at a ratio of 50 µg/cm².

3. The adhesion method of noble metal to a carbon steel material of an atomic energy plant according to Claim 1 or 2,
wherein the nickel metal film (80) is formed by bringing a film forming aqueous solution including a nickel ion and a reductant into contact with the surface of the carbon steel material,
the noble metal is adhered by bringing an aqueous solution including a noble metal ion and a reductant into contact with a surface of the formed nickel metal film (80), and
the forming of the nickel metal film (80) and the adhering of the noble metal are performed before the atomic energy plant starts after an operation of the atomic energy plant is suspended.

4. The adhesion method of noble metal to a carbon steel material of an atomic energy plant according to Claim 3,
wherein pH of the film forming aqueous solution is in a range of 4.0 to 11.0.

5. The adhesion method of noble metal to a carbon steel material of an atomic energy plant according to Claim 1 or 2,
wherein the nickel metal film (80) is formed after chemical decontamination is performed on the surface of the carbon steel material.

6. The adhesion method of noble metal to a carbon steel material of an atomic energy plant according to Claim 5,
wherein an oxidant is injected into an oxalic acid aqueous solution used in the chemical decontamination on the surface.

7. The adhesion method of noble metal to a carbon steel material of an atomic energy plant according to Claim 3 or 4,
wherein the nickel metal film (80) is formed on an inner surface of a first pipe in a manner that the film forming aqueous solution is supplied to the first pipe which communicates with a reactor pressure vessel (2) and is the carbon steel material, through a second pipe, and the film forming aqueous solution is brought into contact with the inner surface of the first pipe, which is the surface of the carbon steel material, and
the noble metal is adhered in a manner that the aqueous solution including the noble metal ion and the reductant is supplied to the first pipe through the second pipe, and the aqueous solution is brought into contact with the surface of the nickel metal film, which has been formed on the inner surface of the first pipe.

8. The adhesion method of noble metal to a carbon steel material of an atomic energy plant according to Claim 7,
wherein the film forming aqueous solution is circulated in a closed loop including the first pipe and the second pipe, and
the aqueous solution including the noble metal ion and the reductant is circulated in the closed loop.

9. The adhesion method of noble metal to a carbon steel material of an atomic energy plant according to Claim 1,
wherein the chrome metal film is formed by either evaporation or plating of chrome to an inner surface of a plurality of pipe constituents as the carbon steel material,
the plurality of pipe constituents having an inner surface on which the chrome metal film has been formed is welded so as to form a first pipe which communicates with a reactor pressure vessel and is the carbon steel material, and
the noble metal is adhered in a manner that an aqueous solution including a noble metal ion and a reductant is supplied to the first pipe through a second pipe, and the aqueous solution is brought into contact with a surface of the chrome metal film which has been formed on an inner surface of the first pipe.

10. An adhesion restraint method of a radionuclide to a carbon steel material of an atomic energy plant, the method comprising:
performing the adhesion method of noble metal to a carbon steel material of an atomic energy plant according to any one of Claims 1 to 6; and
bringing water which includes an oxidant and has a temperature range of 200°C to 330°C into contact with the nickel metal film to which the noble metal adheres, so as to convert the nickel metal film (80) into a nickel ferrite film (82).

11. The adhesion restraint method of a radionuclide to a carbon steel material of an atomic energy plant according to Claim 10,
wherein the atomic energy plant starts,
cooling water which includes an oxidant, has a temperature range of 200°C to 330°C, and has been heated by fission of a nuclear fuel material in a reactor pressure vessel (2) is used as the water which includes the oxidant and has a temperature range of 200°C to 330°C, and
the nickel metal film (80) is converted into the nickel ferrite film (82) by bringing the cooling water into contact with the nickel metal film (80).

12. An adhesion restraint method of a radionuclide to a carbon steel material of an atomic energy plant, the method comprising:
performing the adhesion method of noble metal to a carbon steel material of an atomic energy plant according to Claim 7 or 8;
detaching the second pipe from the first pipe;
supplying water which includes an oxidant and has a temperature range of 200°C to 330°C to the first pipe, after the detaching; and
bringing the water including the oxidant into contact with the nickel metal film (80) which has been formed on an inner surface of the first pipe and has the adhering noble metal, so as to convert the nickel metal film (80) into a nickel ferrite film (82) to which the noble metal adheres.

13. The adhesion restraint method of a radionuclide to a carbon steel material of an atomic energy plant according to Claim 12,
wherein the atomic energy plant starts after the second pipe is detached from the first pipe,
the water including the oxidant is supplied to the first pipe in a manner that cooling water which has been heated by fission of a nuclear fuel material in the reactor pressure vessel (2), includes an oxidant, and has a temperature range of 200°C to 330°C is supplied to the first pipe, and
the nickel metal film (80) to which the noble metal has adhered is converted into the nickel ferrite film by bringing the cooling water into contact with the nickel metal film (80).

14. The adhesion restraint method of a radionuclide to a carbon steel material of an atomic energy plant according to Claim 12,
wherein the second pipe is detached from the first pipe, and then both end portions of a third pipe are connected to the first pipe so as to form a closed loop including the first pipe and the third pipe,
the water including the oxidant is supplied to the first pipe in a manner that the water which includes the oxidant and circulates in the closed loop is heated by a heating device provided on the third pipe, so as to have a temperature range of 200°C to 330°C, and is supplied from the third pipe to the first pipe,
the nickel metal film (80) to which the noble metal has adhered is converted into the nickel ferrite film by bringing the water which has been supplied from the third pipe and includes the oxidant into the nickel metal film (80) formed on an inner surface of the first pipe, and
the nickel metal film (80) is converted into the nickel ferrite film (82) to which the noble metal adheres, and then the third pipe is detached from the first pipe.

15. An adhesion restraint method of a radionuclide to a carbon steel material of an atomic energy plant, the method comprising:
performing the adhesion method of noble metal to a carbon steel material of an atomic energy plant according to Claim 9;
detaching the second pipe from the first pipe;
supplying water which includes an oxidant and has a temperature range of 200°C to 330°C to the first pipe, after the detaching; and
bringing the water including the oxidant into contact with the chrome metal film which has been formed on an inner surface of the first pipe and has the adhering noble metal, so as to convert the chrome metal film into a chrome ferrite film to which the noble metal adheres.

## Patentansprüche

1. Verfahren für die Adhäsion eines Edelmetalls an einem Kohlenstoffstahlmaterial eines Kernkraftwerks, wobei das Verfahren Folgendes umfasst:
Bilden entweder einer Nickelmetallschicht (80) oder einer Chrommetallschicht an einer Oberfläche des Kohlenstoffstahlmaterials des Kernkraftwerks, die in Kontakt mit Kühlwasser kommt, um die Oberfläche mit der gebildeten Metallschicht abzudecken; und
Kleben eines Edelmetalls an der Oberfläche der gebildeten Metallschicht, wobei
das Bilden der Nickelmetallschicht (80) oder der Chrommetallschicht und das Kleben des Edelmetalls durchgeführt werden, wenn das Kernkraftwerk angehalten ist.

2. Verfahren für die Adhäsion eines Edelmetalls an einem Kohlenstoffstahlmaterial eines Kernkraftwerks nach Anspruch 1, wobei
das Nickelmetall, das in der Nickelmetallschicht enthalten ist, an der Oberfläche mit einem Anteil von 50 µg/cm² vorgesehen ist.

3. Verfahren für die Adhäsion eines Edelmetalls an einem Kohlenstoffstahlmaterial eines Kernkraftwerks nach Anspruch 1 oder 2, wobei
die Nickelmetallschicht (80) gebildet wird, indem eine schichtbildende wässrige Lösung, die ein Nickel-Ion und ein Reduktionsmittel enthält, in Kontakt mit der Oberfläche des Kohlenstoffstahlmaterials gebracht wird,
das Edelmetall geklebt wird, indem eine wässrige Lösung, die ein Edelmetall-lon und ein Reduktionsmittel enthält, in Kontakt mit einer Oberfläche der gebildeten Nickelmetallschicht (80) gebracht wird, und
das Bilden der Nickelmetallschicht (80) und das Kleben des Edelmetalls durchgeführt werden, bevor das Kernkraftwerk anläuft, nachdem der Betrieb des Kernkraftwerks angehalten worden ist.

4. Verfahren für die Adhäsion eines Edelmetalls an einem Kohlenstoffstahlmaterial eines Kernkraftwerks nach Anspruch 3, wobei
der ph-Wert der schichtbildenden wässrigen Lösung im Bereich von 4,0 bis 11,0 liegt.

5. Verfahren für die Adhäsion eines Edelmetalls an einem Kohlenstoffstahlmaterial eines Kernkraftwerks nach Anspruch 1 oder 2, wobei
die Nickelmetallschicht (80) gebildet wird, nachdem eine chemische Dekontamination an der Oberfläche des Kohlenstoffstahlmaterials durchgeführt worden ist.

6. Verfahren für die Adhäsion eines Edelmetalls an einem Kohlenstoffstahlmaterial eines Kernkraftwerks nach Anspruch 5, wobei
ein Oxidationsmittel in eine wässrige Oxalsäurelösung, die in der chemischen Dekontamination an der Oberfläche verwendet wird, eingespeist wird.

7. Verfahren für die Adhäsion eines Edelmetalls an einem Kohlenstoffstahlmaterial eines Kernkraftwerks nach Anspruch 3 oder 4, wobei
die Nickelmetallschicht (80) an einer Innenfläche eines ersten Rohres in der Weise gebildet wird, dass die schichtbildende wässrige Lösung dem ersten Rohr, das mit einem Reaktordruckbehälter (2) verbunden ist und aus dem Kohlenstoffstahlmaterial besteht, durch ein zweites Rohr zugeführt wird und die schichtbildende wässrige Lösung in Kontakt mit der Innenfläche des ersten Rohres, die die Oberfläche des Kohlenstoffstahlmaterials ist, gebracht wird, und
das Edelmetall in der Weise geklebt wird, dass die wässrige Lösung, die das Edelmetall-Ion und das Reduktionsmittel enthält, dem ersten Rohr durch das zweite Rohr zugeführt wird, und die wässrige Lösung in Kontakt mit der Oberfläche der Nickelmetallschicht, die an der Innenfläche des ersten Rohres gebildet worden ist, gebracht wird.

8. Verfahren für die Adhäsion eines Edelmetalls an einem Kohlenstoffstahlmaterial eines Kernkraftwerks nach Anspruch 7, wobei
die schichtbildende wässrige Lösung in einem Regelkreis, der das erste Rohr und das zweite Rohr enthält, zirkuliert wird und
die wässrige Lösung, die das Edelmetall-Ion und das Reduktionsmittel enthält, im Regelkreis zirkuliert wird.

9. Verfahren für die Adhäsion eines Edelmetalls an einem Kohlenstoffstahlmaterial eines Kernkraftwerks nach Anspruch 1, wobei
die Chrommetallschicht durch Verdampfung oder Plattierung von Chrom an eine Innenfläche mehrerer Rohrbestandteile als das Kohlenstoffstahlmaterial gebildet wird,
die mehreren Rohrbestandteile, die eine Innenfläche, an der die Chrommetallschicht gebildet worden ist, besitzen, derart verschweißt werden, dass sie ein erstes Rohr bilden, das mit einem Reaktordruckbehälter verbunden ist und aus dem Kohlenstoffstahlmaterial besteht, und
das Edelmetall in der Weise geklebt wird, dass eine wässrige Lösung, die ein Edelmetall-Ion und ein Reduktionsmittel enthält, dem ersten Rohr durch ein zweites Rohr zugeführt wird und die wässrige Lösung in Kontakt mit einer Oberfläche der Chrommetallschicht, die an einer Innenfläche des ersten Rohres gebildet worden ist, gebracht wird.

10. Adhäsionsrückhalteverfahren eines Radionuklids an ein Kohlenstoffstahlmaterial eines Kernkraftwerks, wobei das Verfahren Folgendes umfasst:
Durchführen des Adhäsionsverfahrens eines Edelmetalls an ein Kohlenstoffstahlmaterial eines Kernkraftwerks nach einem der Ansprüche 1 bis 6 und
in Kontakt Bringen von Wasser, das ein Oxidationsmittel enthält und einen Temperaturbereich von 200 °C bis 330 °C besitzt, mit der Nickelmetallschicht, an der das Edelmetall klebt, um die Nickelmetallschicht (80) in eine Nickelferritschicht (82) umzuwandeln.

11. Adhäsionsrückhalteverfahren eines Radionuklids an ein Kohlenstoffstahlmaterial eines Kernkraftwerks nach Anspruch 10, wobei
das Kernkraftwerk anläuft,
Kühlwasser, das ein Oxidationsmittel enthält, einen Temperaturbereich von 200 °C bis 330 °C besitzt, und durch Fission eines Nuklearbrennstoffmaterials in einem Reaktordruckbehälter (2) erwärmt worden ist, als das Wasser, das das Oxidationsmittel enthält und einen Temperaturbereich von 200 °C bis 330 °C besitzt, verwendet wird und
die Nickelmetallschicht (80) in die Nickelferritschicht (82) umgewandelt wird, indem das Kühlwasser in Kontakt mit der Nickelmetallschicht (80) gebracht wird.

12. Adhäsionsrückhalteverfahren eines Radionuklids an ein Kohlenstoffstahlmaterial eines Kernkraftwerks, wobei das Verfahren Folgendes umfasst:
Durchführen des Adhäsionsverfahrens eines Edelmetalls an ein Kohlenstoffstahlmaterial eines Kernkraftwerks nach Anspruch 7 oder 8;
Trennen des zweiten Rohres vom ersten Rohr;
Zuführen von Wasser, das ein Oxidationsmittel enthält und einen Temperaturbereich von 200 °C bis 330 °C besitzt, zum ersten Rohr nach dem Trennen; und
Bringen des Wassers, das das Oxidationsmittel enthält, in Kontakt mit der Nickelmetallschicht (80), die an einer Innenfläche der ersten Rohres gebildet worden ist und das klebende Edelmetall besitzt, um die Nickelmetallschicht (80) in eine Nickelferritschicht (82), an der das Edelmetall klebt, umzuwandeln.

13. Adhäsionsrückhalteverfahren eines Radionuklids an ein Kohlenstoffstahlmaterial eines Kernkraftwerks nach Anspruch 12, wobei
das Kernkraftwerk anläuft, nachdem das zweite Rohr vom ersten Rohr getrennt worden ist,
das Wasser, das das Oxidationsmittel enthält, dem ersten Rohr in der Weise zugeführt wird, dass Kühlwasser, das durch Fission eines Nuklearbrennstoffmaterials im Reaktordruckbehälter (2) erwärmt worden ist, ein Oxidationsmittel enthält und einen Temperaturbereich von 200 °C bis 330 °C besitzt, dem ersten Rohr zugeführt wird, und
die Nickelmetallschicht (80), an der das Edelmetall klebt, in die Nickelferritschicht (82) umgewandelt wird, indem das Kühlwasser in Kontakt mit der Nickelmetallschicht (80) gebracht wird.

14. Adhäsionsrückhalteverfahren eines Radionuklids an ein Kohlenstoffstahlmaterial eines Kernkraftwerks nach Anspruch 12, wobei
das zweite Rohr vom erste Rohr getrennt wird und dann beide Endabschnitte eines dritten Rohres derart mit dem ersten Rohr verbunden werden, dass ein Regelkreis, der das erste Rohr und das dritte Rohr enthält, gebildet wird,
das Wasser, das das Oxidationsmittel enthält, dem ersten Rohr in der Weise zugeführt wird, dass das Wasser, das das Oxidationsmittel enthält und im Regelkreis zirkuliert, durch eine Heizeinrichtung, die im dritten Rohr vorgesehen ist, derart erwärmt wird, dass es einen Temperaturbereich von 200 °C bis 330 °C besitzt, und vom dritten Rohr dem ersten Rohr zugeführt wird,
die Nickelmetallschicht (80), an der das Edelmetall klebt, in die Nickelferritschicht umgewandelt wird, indem das Wasser, das vom dritten Rohr zugeführt worden ist und das Oxidationsmittel enthält, in die Nickelmetallschicht (80), die an einer Innenfläche des ersten Rohres gebildet ist, gebracht wird, und
die Nickelmetallschicht (80) in die Nickelferritschicht (82), an der das Edelmetall klebt, umgewandelt wird und dann das dritte Rohr vom ersten Rohr getrennt wird.

15. Adhäsionsrückhalteverfahren eines Radionuklids an ein Kohlenstoffstahlmaterial eines Kernkraftwerks, wobei das Verfahren Folgendes umfasst:
Durchführen des Adhäsionsverfahrens eines Edelmetalls an ein Kohlenstoffstahlmaterial eines Kernkraftwerks nach Anspruch 9;
Trennen des zweiten Rohres vom ersten Rohr;
Zuführen von Wasser, das ein Oxidationsmittel enthält und einen Temperaturbereich von 200 °C bis 330 °C besitzt, zum ersten Rohr nach dem Trennen; und
Bringen des Wassers, das das Oxidationsmittel enthält, in Kontakt mit der Chrommetallschicht, die an einer Innenfläche der ersten Rohres gebildet worden ist und das klebende Edelmetall besitzt, um die Chrommetallschicht in eine Chromferritschicht, an der das Edelmetall klebt, umzuwandeln.

## Revendications

1. Procédé d'adhérence d'un métal noble sur un matériau en acier au carbone d'une installation de production d'énergie atomique, le procédé comprenant les étapes consistant à :
former soit un film de nickel métallique (80), soit un film de chrome métallique, sur une surface du matériau en acier au carbone de l'installation de production d'énergie atomique, qui vient en contact avec de l'eau de refroidissement de manière à couvrir la surface avec le film métallique formé ; et
faire adhérer un métal noble sur la surface du film métallique formé, dans lequel l'étape consistant à former soit le film de nickel métallique (80), soit le film de chrome métallique, et l'étape consistant à faire adhérer le métal noble sont exécutées quand l'installation de production d'énergie atomique est arrêtée.

2. Procédé d'adhérence d'un métal noble sur un matériau en acier au carbone d'une installation de production d'énergie atomique selon la revendication 1,
dans lequel le nickel métallique contenu dans le film de nickel métallique est prévu sur la surface à un rapport de 50 µg/cm².

3. Procédé d'adhérence d'un métal noble sur un matériau en acier au carbone d'une installation de production d'énergie atomique selon la revendication 1 ou 2,
dans lequel le film de nickel métallique (80) est formé en amenant une solution aqueuse formant film incluant un ion nickel et un réducteur au contact de la surface du matériau en acier au carbone,
le métal noble est amené à adhérer en amenant une solution aqueuse incluant un ion de métal noble et un réducteur au contact d'une surface du film de nickel métallique formé (80), et
la formation du film de nickel métallique (80) et l'adhérence du métal noble sont exécutées avant le démarrage de l'installation de production d'énergie atomique après que le fonctionnement de l'installation de production d'énergie atomique est arrêté.

4. Procédé d'adhérence d'un métal noble sur un matériau en acier au carbone d'une installation de production d'énergie atomique selon la revendication 3,
dans lequel le pH de la solution aqueuse formant film est dans une plage de 4,0 à 11,0.

5. Procédé d'adhérence d'un métal noble sur un matériau en acier au carbone d'une installation de production d'énergie atomique selon la revendication 1 ou 2, dans lequel le film de nickel métallique (80) est formé après qu'une décontamination chimique est exécutée sur la surface du matériau en acier au carbone.

6. Procédé d'adhérence d'un métal noble sur un matériau en acier au carbone d'une installation de production d'énergie atomique selon la revendication 5,
dans lequel un oxydant est injecté dans une solution aqueuse d'acide oxalique utilisée dans la décontamination chimique sur la surface.

7. Procédé d'adhérence d'un métal noble sur un matériau en acier au carbone d'une installation de production d'énergie atomique selon la revendication 3 ou 4,
dans lequel le film de nickel métallique (80) est formé sur une surface intérieure d'un premier tube de telle manière que la solution aqueuse formant film est approvisionnée vers le premier tube qui communique avec une cuve sous pression d'un réacteur (2) et est le matériau en acier au carbone, à travers un deuxième tube, et la solution aqueuse formant film est amenée au contact de la surface intérieure du premier tube, qui est la surface du matériau en acier au carbone, et
le métal noble est amené à adhérer de telle manière que la solution aqueuse incluant l'ion de métal noble et le réducteur est approvisionnée vers le premier tube à travers le deuxième tube, et la solution aqueuse est amenée au contact de la surface du film de nickel métallique qui a été formé sur la surface intérieure du premier tube.

8. Procédé d'adhérence d'un métal noble sur un matériau en acier au carbone d'une installation de production d'énergie atomique selon la revendication 7,
dans lequel la solution aqueuse formant film est mise en circulation dans une boucle fermée incluant le premier tube et le deuxième tube, et
la solution aqueuse incluant l'ion de métal noble et le réducteur est mise en circulation dans la boucle fermée.

9. Procédé d'adhérence d'un métal noble sur un matériau en acier au carbone d'une installation de production d'énergie atomique selon la revendication 1,
dans lequel le film de chrome métallique est formé soit par évaporation, soit par placage de chrome sur une surface intérieure d'une pluralité de constituants de tube à titre de matériau en acier au carbone,
la pluralité de constituants de tube ayant une surface intérieure sur laquelle le film de chrome métallique a été formé sont soudés de manière à former un premier tube qui communique avec une cuve sous pression d'un réacteur, et sont le matériau en acier au carbone, et
le métal noble est amené à adhérer de telle manière qu'une solution aqueuse incluant un ion de métal noble et un réducteur est approvisionnée vers le premier tube à travers un deuxième tube, et la solution aqueuse est amenée au contact d'une surface du film de chrome métallique qui a été formé sur une surface intérieure du premier tube.

10. Procédé de retenue d'adhérence d'un radionucléide sur un matériau en acier au carbone d'une installation de production d'énergie atomique, le procédé comprenant les étapes consistant à :
exécuter le procédé d'adhérence d'un métal noble sur un matériau en acier au carbone d'une installation de production d'énergie atomique selon l'une quelconque des revendications 1 à 6 ; et
amener de l'eau qui inclut un oxydant et a une plage de température de 200 °C à 330 °C au contact du film de nickel métallique sur lequel adhère le métal noble de manière à transformer le film de nickel métallique (80) en un film de nickel ferritique (82).

11. Procédé de retenue d'adhérence d'un radionucléide sur un matériau en acier au carbone d'une installation de production d'énergie atomique selon la revendication 10,
dans lequel l'installation de production d'énergie atomique démarre,
de l'eau de refroidissement qui inclut un oxydant, a une plage de température de 200 °C à 330 °C, et a été chauffée par fission d'un matériau combustible nucléaire dans une cuve sous pression d'un réacteur (2), est utilisée comme étant l'eau qui inclut l'oxydant et a une température de 200 °C à 330 °C, et
le film de nickel métallique (80) est transformé en film de nickel ferritique (82) en amenant l'eau de refroidissement au contact du film de nickel métallique (80).

12. Procédé de retenue d'adhérence d'un radionucléide sur un matériau en acier au carbone d'une installation de production d'énergie atomique, le procédé comprenant les étapes consistant à :
exécuter le procédé d'adhérence d'un métal noble sur un matériau en acier au carbone d'une installation de production d'énergie atomique selon la revendication 7 ou 8 ;
détacher le deuxième tube du premier tube ;
approvisionner de l'eau qui inclut un oxydant et a une plage de température de 200 °C à 330 °C vers le premier tube, après le détachement ; et
amener l'eau incluant l'oxydant au contact du film de nickel métallique (80) qui a été formé sur une surface intérieure du premier tube et a le métal noble qui adhère, de manière à transformer le film de nickel métallique (80) en film de nickel ferritique (82) sur lequel le métal noble adhère.

13. Procédé de retenue d'adhérence d'un radionucléide sur un matériau en acier au carbone d'une installation de production d'énergie atomique selon la revendication 12,
dans lequel l'installation de production d'énergie atomique démarre après que le deuxième tube est détaché du premier tube,
l'eau incluant l'oxydant est approvisionnée vers le premier tube de telle manière que l'eau de refroidissement qui a été chauffée par fission d'un matériau combustible nucléaire dans la cuve sous pression d'un réacteur (2), inclut un oxydant, et a une plage de température de 200 °C à 330 °C, est approvisionnée vers le premier tube, et
le film de nickel métallique (80) sur lequel le métal noble a adhéré est transformé en film de nickel ferritique en amenant l'eau de refroidissement au contact du film de nickel métallique (80).

14. Procédé de retenue d'adhérence d'un radionucléide sur un matériau en acier au carbone d'une installation de production d'énergie atomique selon la revendication 12,
dans lequel le deuxième tube est détaché du premier tube, et puis les deux portions terminales d'un troisième tube sont connectées au premier tube de manière à former une boucle fermée incluant le premier tube et le troisième tube,
l'eau incluant l'oxydant est approvisionnée vers le premier tube de telle manière que l'eau qui inclut l'oxydant et circule dans la boucle fermée est chauffée par un dispositif de chauffage prévu sur le troisième tube pour avoir une plage de température de 200 °C à 330 °C, et est approvisionnée depuis le troisième tube vers le premier tube,
le film de de nickel métallique (80) sur lequel le métal noble a adhéré est transformé en film de nickel ferritique en amenant l'eau qui a été approvisionnée depuis le troisième tube et inclut l'oxydant jusque dans le film de nickel métallique (80) formé sur une surface intérieure du premier tube, et
le film de nickel métallique (80) est transformé en film de nickel ferritique (82) sur lequel le métal noble adhère, et puis le troisième tube est détaché du premier tube.

15. Procédé de retenue d'adhérence d'un radionucléide sur un matériau en acier au carbone d'une installation de production d'énergie atomique, le procédé comprenant les étapes consistant à :
exécuter le procédé d'adhérence d'un métal noble sur un matériau en acier au carbone d'une installation de production d'énergie atomique selon la revendication 9 ;
détacher le deuxième tube du premier tube ;
approvisionner de l'eau qui inclut un oxydant et a une plage de température de 200 °C à 330 °C vers le premier tube, après le détachement ; et
amener l'eau incluant l'oxydant au contact du film de chrome métallique qui a été formé sur une surface intérieure du premier tube et a le métal noble qui adhère, de manière à transformer le film de chrome métallique en film de chrome ferritique sur lequel le métal noble adhère.
